# EUROPEAN PATENT APPLICATION

(11) **EP 4 773 031 A1**
(43) Date of publication of application: **08.07.2026**
(21) Application number: 25315001.5
(22) Date of filing: 02.01.2025
(51) Int. Cl.: G06F 30/12, G06F 30/27, G06N 3/02

(54) **MACHINE-LEARNING A FUNCTION CONFIGURED FOR PREDICTING A NEXT CAD FEATURE IN A CAD FEATURE TREE**

(71) Applicant: Dassault Systèmes, 78140 Vélizy-Villacoublay (FR)
(72) Inventor: Pagliughi, Pierre, 78140 Vélizy-Villacoublay (FR); Degas, Christopher, 78140 Vélizy-Villacoublay (FR); Hu, Alexia, 78140 Vélizy-Villacoublay (FR); Zhang, Zhenchen, 78140 Vélizy-Villacoublay (FR); Lerondeau, Theodore, 78140 Vélizy-Villacoublay (FR); Pollet, Nathan, 78140 Vélizy-Villacoublay (FR)
(74) Representative: Bandpay & Greuter

(57) **Abstract**

The disclosure relates to a machine-learning method for learning a function configured for predicting a next feature in a feature tree. The method comprises providing a dataset of examples each comprising a graph representing at least a part of a feature tree. The graph comprises nodes each representing a feature and each labeled with a label of a set of labels each indicating a feature type of a predetermined set. The graph comprises edges each connecting nodes and representing a parent-child relationship between the features represented by the nodes. The graph comprises ground truth data indicating a next feature according to one or more selected features each corresponding to a graph node. The method further comprises training the function to take as input a graph representing at least a part of a feature tree and to output a prediction of one or more next features in the feature tree.

## Description

### TECHNICAL FIELD

The disclosure relates to the field of computer programs and systems, and more specifically to a method, system and program for machine-learning a function configured for predicting a next CAD feature in a CAD feature tree, to a function learnable according to the method, and to a method of use of such function.

### BACKGROUND

A number of solutions, hardware and software, are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for analyzing and simulating the physical behavior of a future product. CAM is an acronym for Computer-Aided Manufacturing, e.g. it relates to software solutions for defining product manufacturing processes and resources. In such computer-aided design solutions, the graphical user interface plays an important role as regards the efficiency of the technique. These techniques may be embedded within Product Lifecycle Management (PLM) solutions. PLM refers to an engineering strategy that helps companies to share product data, apply common processes, and leverage corporate knowledge for the development of products from conception to the end of their life, across the concept of extended enterprise. The PLM solutions provided by Dassault Systemes (under the trademarks CATIA, SIMULIA, DELMIA and ENOVIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the solutions deliver common models linking products, processes, resources to enable dynamic, knowledge-based product creation and decision support that drives optimized product definition, manufacturing preparation, production and service.

In this context, design and manufacturing software solutions commonly use so-called feature-based CAD models, which are CAD models defined by a CAD feature tree (sometimes simply referred to as "feature tree" hereinafter). These concepts are further described hereinafter, but essentially, a CAD feature tree is a sequence of operations (also referred to as CAD features), organized in the form of a tree, of which execution creates the geometry of the CAD model (for example in the B-rep format). A CAD model defined by a feature tree and/or by the B-rep representation obtained by executing that feature tree is normally a model which is manufacturable, *i.e.* it defines the exact geometry for manufacturing the mechanical part which the model represents. For example, as further discussed hereinafter, such model can be converted into a CAM (Computer-Aided Manufacturing) file or the like for further manufacturing.

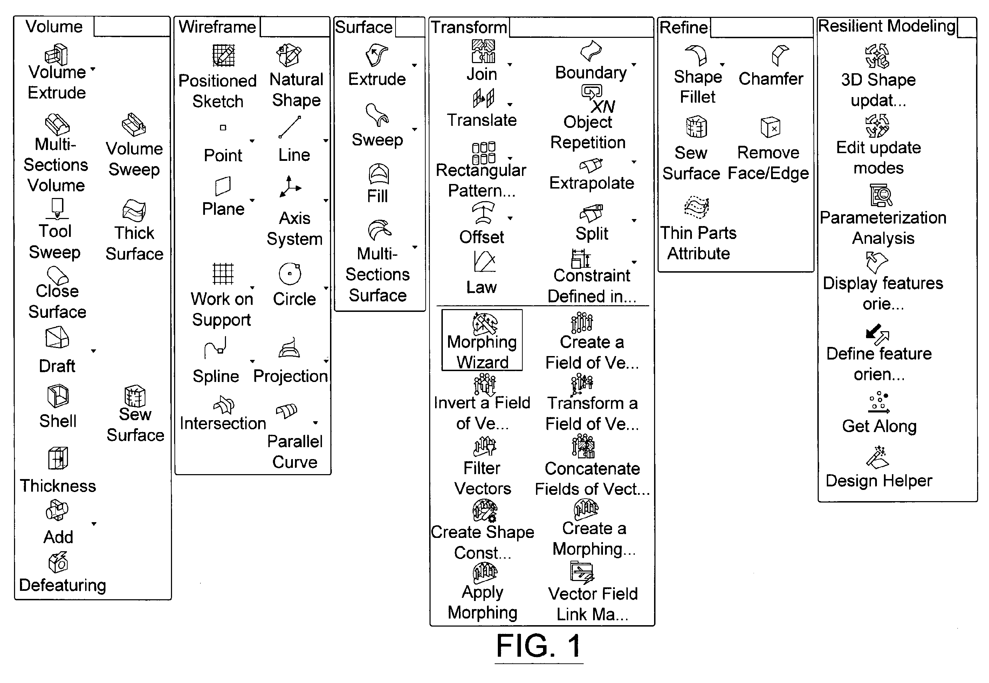

Designing a CAD feature tree of a CAD model is thus a typical important step in a design and manufacturing process. Software solutions, like CATIA, exist to achieve this task. Typically, such solutions offer the user a large set of CAD features (possibly also referred to as "commands" in the present disclosure). For example, for the software application CATIA Generative Shape Design, there are about 250 available CAD features. This large set of commands may provide the perception to the user that the software solution is very complex and not very intuitive. In fact, some new users may spend time searching for the right command to use at the right time for their design process. The commands are typically displayed in a menu of selectable commands which is not at all ergonomic to browse: it requires time and eye focus of the user to browse the menu, and possibly numerous clicks (or touches) on the menu for command selection and/or going through sub-menus. FIG. 1 shows an example of such a menu in the CATIA Generative Shape Design software solution. As can be seen in the figure, selecting the right CAD feature may require time and eye focus, especially for the unexperienced user, and possibly several user-machine interactions to go through submenus (some commands are accessible by clicking on the vertical arrows).

Current design processes for designing a CAD feature tree are thus typically long and cumbersome for the end user and lack ergonomy. In addition, there are some best practices that are captured by companies in order to use more some commands than others as they are more robust to design change (resilient), and these best practices are not at all apparent or captured on the displayed set (e.g. menu) of CAD features.

There is thus a need for improved solutions for the design/creation of a CAD feature tree.

### SUMMARY

It is therefore provided a computer-implemented method for machine-learning a function. The function is configured for predicting a next CAD feature in a CAD feature tree. The method comprises providing a training dataset of training examples. Each training example comprises a graph. The graph represents at least a part of a respective CAD feature tree. The graph comprises nodes. Each node represents a CAD feature of the respective CAD feature tree. Each node is labeled with a label of a predetermined set of labels each indicating a type of CAD feature of a predetermined set of CAD feature types. The graph also comprises edges. Each edge connects two nodes and represents a parent-child relationship, in the respective CAD feature tree, between the CAD features represented by the two nodes. The graph also comprises ground truth data indicating a next CAD feature to predict according to one or more selected CAD features each corresponding to a node of the graph. The method further comprises training the function based on the training dataset. The function is trained to take as input a graph representing at least a part of a CAD feature tree and to output a prediction of one or more next CAD features in the CAD feature tree. Each predicted next CAD feature belongs to the predetermined set of CAD feature types. The method may be referred to as "the learning method".

The method may comprise one or more of the following:
- each training example further comprises data describing a global architecture of the respective CAD feature tree;
- the global data includes data describing:
   ∘ a number of CAD features in the respective CAD feature tree;
   ∘ a number of the one or more selected CAD features based on which a next CAD feature will be based;
   ∘ a dimension homogeneity of the one or more selected CAD features; and/or
   ∘ a number of different geometries of the respective CAD feature tree;
- the function is a neural network comprising:
   ∘ a Graph Neural Network (GNN) configured to take as input the input graph representing at least a part of a CAD feature tree and to output an encoding of the input graph;
   ∘ a linear encoder configured to encode the data describing the global architecture in a global feature encoding;
   ∘ a fusion module configured to output a fusion encoding corresponding to a fusion of the global feature encoding and of the encoding of the input graph; and
   ∘ a classifying module configured to take as input the fusion encoding and to output a the prediction of one or more next CAD features in the CAD feature tree;
- each node comprises node attributes describing geometrical features of the geometry created by the CAD feature represented by the node;
- the method comprises forming the training dataset, the forming the training dataset comprising:
   ∘ providing an initial set of graphs each representing a respective complete CAD feature tree, each graph of the initial set comprising:
      ∘ nodes each representing a CAD feature of the respective complete CAD feature tree, each node being labeled with a label of a predetermined list of labels each indicating a type of CAD feature of a predetermined set of CAD features; and
      ∘ edges each connecting two nodes and representing a parent-child relationship, in the respective complete CAD feature tree, between the CAD features represented by the two nodes;
      o for each graph of the initial set, extracting subgraphs of the graph each representing at least a part of the respective CAD feature tree represented by the graph, the subgraphs thereby forming the training examples;
- the subgraphs have different depths;
   ∘ forming the training dataset further comprises:
      ∘ identifying one or more groups each of topologically similar subgraphs;
      ∘ for each group, selecting a subgraph representative of the group and labeling the selected subgraph with the labels of the other subgraphs of the group; and
      ∘ removing said other subgraphs;
- providing the initial set of graphs comprises:
   ∘ providing a set of CAD feature trees;
   ∘ converting each CAD feature tree into a JSON file; and
   o for each JSON file, forming a graph of the initial set based on the JSON file, the graph representing the respective CAD feature tree corresponding to the JSON file; and/or
- providing the initial set of graphs further comprises, in each graph of the initial set, removing nodes corresponding to a CAD parameter, to a geometry not parameterized by a CAD feature, or a pure B-rep element.

It is also provided a function learnable according to the learning method, *i.e. a* computer-implemented data structure forming the function and having weights/parameters which have value identical as values that would be set by the training of the learning method. The provided function may for example be the function that results from the training according to the learning method, *i.e.* having weights/parameters having values set by the training of the learning method

It is also provided a computer-implemented method of use of the function. The method of use comprises one or more iterations. Each iteration comprises providing a CAD feature tree. The iteration further comprises, by a user, graphically selecting one or more CAD features in the CAD feature tree or one or more geometries created from the one or more CAD features. The iteration further comprises, by using the function, predicting one or more next CAD features to add to the CAD feature tree based on the user selection. The iteration further comprises displaying graphical representations of the predicted one or more CAD feature to the user. The iteration further comprises, by the user, selecting a predicted CAD feature by graphically selecting the displayed graphical representation of the predicted CAD feature, thereby adding the CAD feature to the CAD feature tree. If there is more than one iteration, at each iteration, the CAD feature tree to which the user-selected CAD feature is added forms the provided CAD feature tree of the next iteration. The method of use of the function may be simply referred to as "the method of use".

It is further provided a computer program comprising instructions for performing the learning method and/or the method of use.

It is further provided a computer readable storage medium having recorded thereon the computer program and/or the function.

It is further provided a system comprising a processor coupled to a memory, the memory having recorded thereon the computer program and/or the function.

It is further provided a device comprising a data storage medium having recorded thereon the computer program and/or the function.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (*e.g*. the device is a subsystem of the overall system). The system may further comprise a graphical user interface coupled to the processor.

### BRIEF DESCRIPTION OF THE DRAWINGS

Non-limiting examples will now be described in reference to the accompanying drawings, where:
- FIG.s 1 to 25 illustrate the methods; and

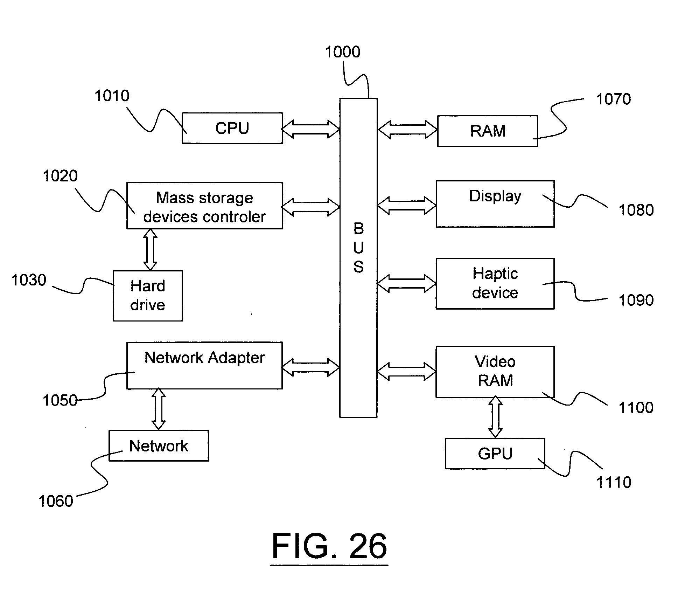

- FIG. 26 shows an example of the system.

### DETAILED DESCRIPTION

It is proposed a computer-implemented method for machine-learning a function. The function is configured for predicting a next CAD feature in a CAD feature tree. The method comprises providing a training dataset of training examples. Each training example comprises a graph. The graph represents at least a part of a respective CAD feature tree. The graph comprises nodes. Each node represents a CAD feature of the respective CAD feature tree. Each node is labeled with a label of a predetermined set of labels each indicating a type of CAD feature of a predetermined set of CAD feature types. The graph also comprises edges. Each edge connects two nodes and represents a parent-child relationship, in the respective CAD feature tree, between the CAD features represented by the two nodes. The graph also comprises ground truth data indicating a next CAD feature to predict according to one or more selected CAD features each corresponding to a node of the graph. The method further comprises training the function based on the training dataset. The function is trained to take as input a graph representing at least a part of a CAD feature tree and to output a prediction of one or more next CAD features in the CAD feature tree. Each predicted next CAD feature belongs to the predetermined set of CAD feature types. The method may be referred to as "the learning method", as previously discussed.

The learning method constitutes an improved solution for the design/creation/determination of a CAD feature tree.

Notably, the method trains a function to take as input a graph which represents at least a part of a CAD feature tree, such as a graph representing a portion of the feature tree, *i.e.* a partial feature tree, during the process of design/creation of the complete one, and to predict one or more next CAD features in the tree, *i.e.* a set of all technically possible next CAD features to add in the tree to continue its creation. The function learnt by the method thus leverages/benefits from generative Al capabilities to predict the right set of commands to continue a current design sequence. The method thus provides a powerful generative Artificial Intelligence (AI) tool (the function) that improves efficiency and ergonomics of the feature tree design process (as compared to the user manual iterative selection of the features in the current design software solutions), providing automatic predictions of suitable next CAD features based on a current state of the tree. Furthermore, the training dataset can be set so as to comprise only or a sufficient/significant number of training examples that respect best CAD feature tree practices, *e.g.* specific sequences/order of CAD operations that are designed to meet some constraints (*e.g.* use constraints, manufacturing constraints, and/or constraint to use a minimal number of CAD feature to optimize storage of the CAD model). In this case the methods provide a powerful generative Al that allows a user to respect best practices with improved efficiency and ergonomy.

These effects and advantages especially materialize in the method of use. The method of use comprises one or more iterations. Each iteration comprises providing a CAD feature tree. The iteration further comprises, by a user, graphically selecting one or more CAD features in the CAD feature tree or one or more geometries created from the one or more CAD features. The iteration further comprises, by using the function, predicting one or more next CAD features to add to the CAD feature tree based on the user selection. The iteration further comprises displaying graphical representations of the predicted one or more CAD feature to the user. The iteration further comprises, by the user, selecting a predicted CAD feature by graphically selecting the displayed graphical representation of the predicted CAD feature, thereby adding the CAD feature to the CAD feature tree. If there is more than one iteration, at each iteration, the CAD feature tree to which the user-selected CAD feature is added forms the provided CAD feature tree of the next iteration.

As can be seen in the method of use, during a design sequence, the user graphically selects a CAD feature (or equivalently the geometry resulting from that feature) in the partial feature tree being designed, upon which the function automatically predicts one or more next CAD features to add in the tree and that would be suitable to follow the user selection. The predicted feature(s) can then be displayed to the user, which may graphically select the one to add to the tree as the next feature, and the method of use may then proceed to the next iteration. The creation of the feature tree is thus particularly efficient and ergonomic, with the user only performing graphical selections of a geometry (or CAD feature) of interest and the system automatically providing predictions of the suitable next feature(s) instead of the user having to manually browse a complex menu to find them.

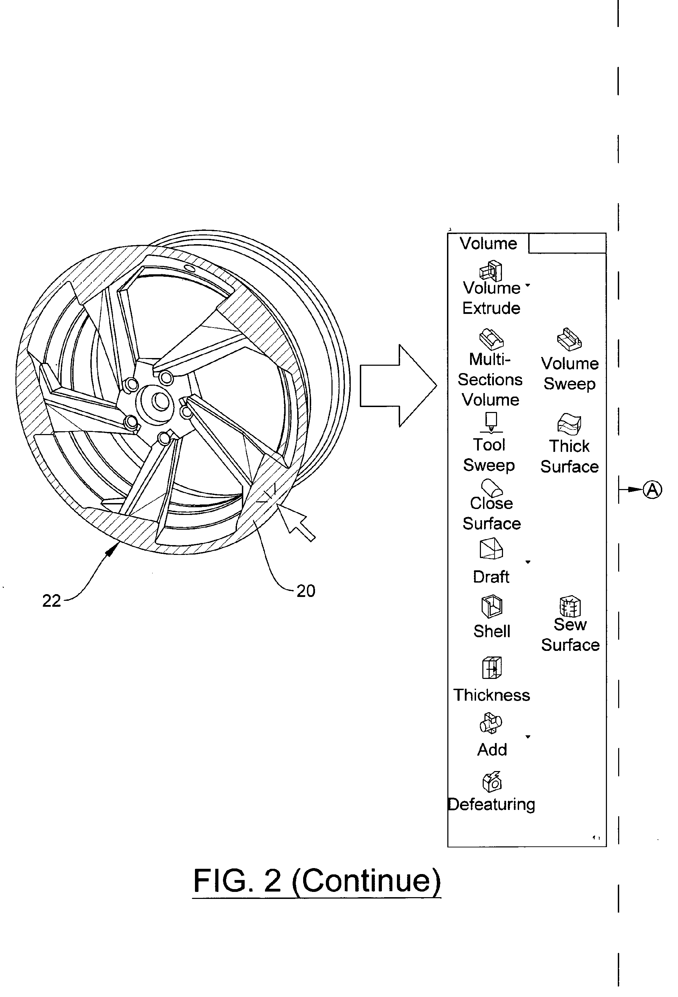

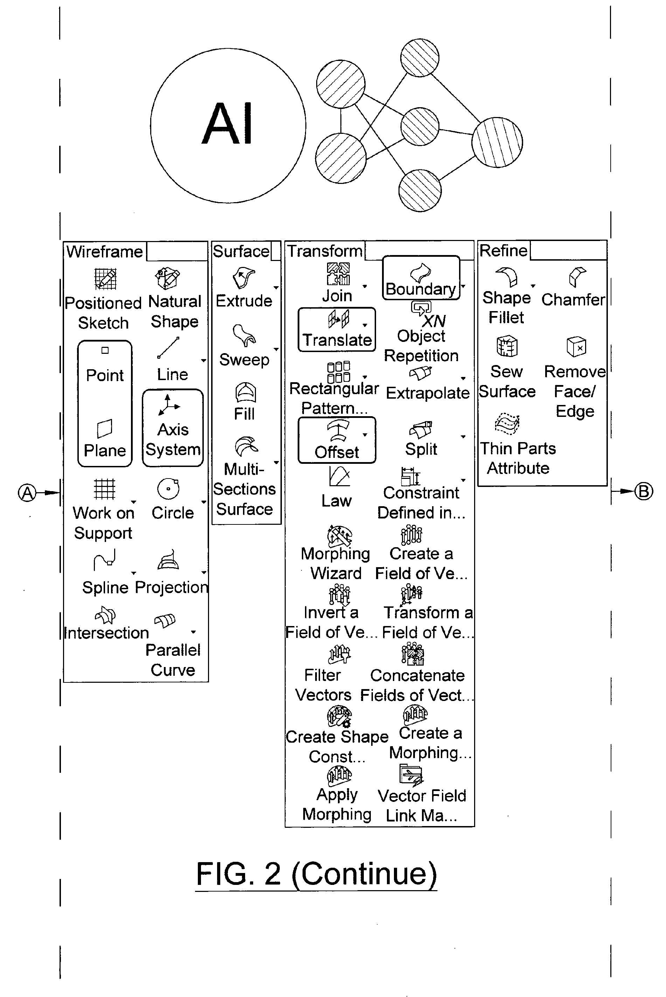

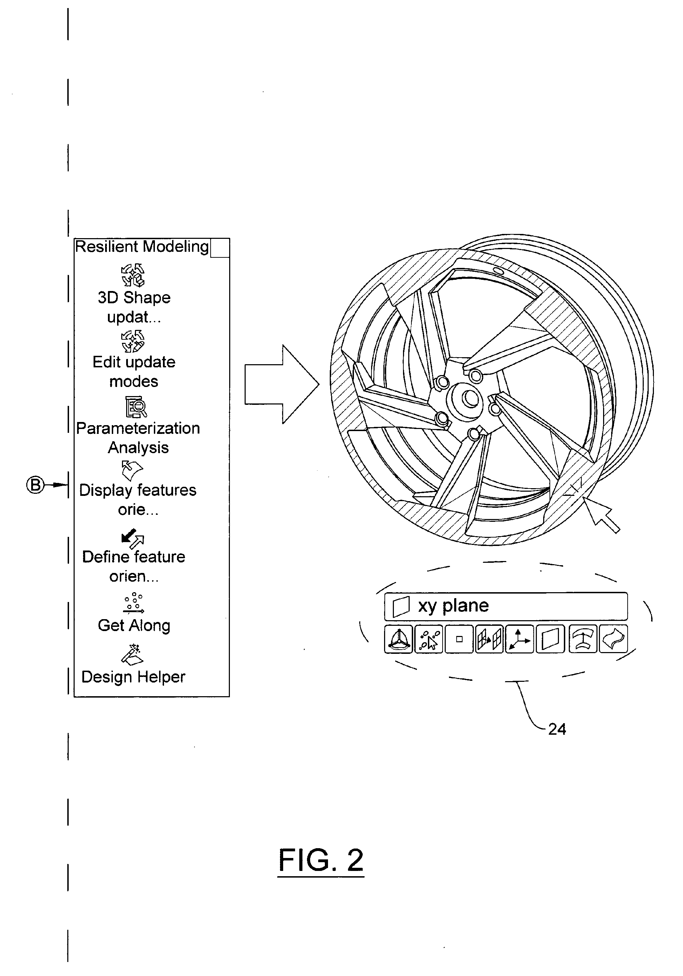

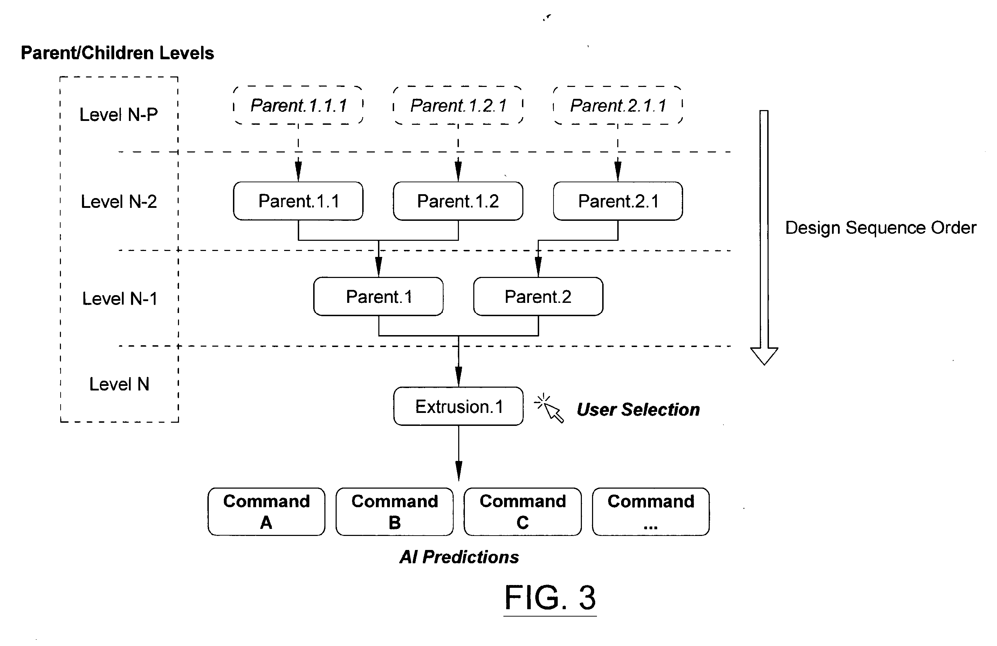

The methods of the present disclosure and these effects and advantages are illustrated by FIG. 2 and FIG. 3. FIG. 2 illustrates how the user graphically selects (by clicking) on a geometry 20 of a mechanical part 22 (which is a car wheel rim), and the function (symbol "Al" in the figure) provides a graphical display of a set 24 of predictions of next CAD features to add to the feature tree based on the user selection. FIG. 3 shows the corresponding illustration from the viewpoint of the feature tree itself.

The learning method is now further discussed.

The learning method is a method of machine-learning. As known *per se* from the field of machine-learning, the processing of an input by a model or function includes applying operations to the input, the operations being defined by data including weight values or parameters. Learning a model/function (*e.g.* a neural network or a regressor) thus includes determining values of the weights/parameters based on a dataset configured for such learning, such a dataset being possibly referred to as a learning dataset or a training dataset. For that, the dataset includes data pieces each forming a respective training sample or training example. The training samples/examples represent the diversity of the situations where the model is to be used after being learnt. Any training dataset herein may comprise a number of training samples/examples higher than 1000, 10000, 100000, or 1000000. In the context of the present disclosure, by "learning a model based on a dataset", it is meant that the dataset is a learning/training dataset of the model, based on which the values of the weights/parameters are set. In the present disclosure, the training dataset is the dataset of training examples, on which the function is trained.

As known *per se* from machine-learning, a neural network may be defined by its architecture, parameters, and hyperparameters. The architecture consists of layers, starting with the input layer whose neuron count may be determined by the dimensionality of the input data. This layer is followed by several hidden layers with a given number of neurons and activation functions. These layers and neurons define the network's depth and width, while the activation functions may introduce nonlinearity into the model. The output layer may have as many neurons as the variables in the output data. The interconnections between these layers defines the topology of the neural network. The parameters of the neural network are the learnable weights and biases, which are determined in the training process. In contrast, the hyperparameters are pre-defined settings that are not learned from the training data. These encompasses the number of hidden layers, neurons per layer and much more. To train a neural network, at least two settings may be defined. First, a loss function, which is a metric that measures the error between the training data and the model's prediction, such as the mean square error (MSE). Second, an optimizer, which modifies the model's weights and biases during the training process to minimize the loss function. Each optimizer has its own set of hyperparameters.

The method learns the function, which is configured for predicting a next CAD feature in a CAD feature tree. This means that the function has the architecture for, and is trained for by the learning method, predicting this next CAD feature. In specific, the function is trained for and has the architecture for taking as input a graph representation of at least part of a CAD feature (*i.e.* a CAD feature under construction, thus possibly partial) and outputting a prediction of one or more next CAD features in the CAD feature tree (*i.e.* one or more prediction of a next CAD feature to add as the next CAD feature in the at least a part of the CAD feature tree). The output of the learning method is thus this trained function.

The learning method comprises providing a training dataset, on which the training is then performed. The training dataset consists of training examples, *i.e.* in a sufficient number and variability as known *per se* in the art of machine-learning. Each training example comprises a graph (*i.e.* a respective graph) which represents at least a part of a respective CAD feature tree. In other words, the graph may represent the whole feature tree or a portion thereof (*e.g.* a subtree). The training examples altogether comprise a sufficient number and variability in that respect, *i.e.* there is a sufficient number and variability of graphs in terms of size (or depth) to make the function encounter a suitable diversity of examples during its training to ensure robustness. These considerations related to diversity of the training examples are well-known in machine learning. Each graph comprises nodes and edges each connecting two nodes.

Each node represents a CAD feature of the respective CAD feature tree which the graph represents. Each node is labeled with a label of a predetermined set (or list) of labels. The predetermined set of labels consists of several labels, and each label in the set is respective to a respective type of CAD feature and indicates this type among a predetermined set of CAD feature types. A label of a node thus indicates that the node represents a feature of the type indicated by the label. The predetermined set may consist in the following types of CAD feature:
Line: Creates a geometric segment defined by two points. Circle: Generates a rounded shape defined by a center and a radius. Plane: Defines a flat, infinite 2D surface used as a reference for construction or operations.

Point: Marks a specific position in space, often used as a reference. Curve: Constructs a smooth, continuous geometric line that may be opened or closed. Intersect: Calculates the intersection points or curves between two geometries. Project: Projects a geometry onto a plane or surface. CurvePar: Creates a curve parameterized along a specific mathematical function or relation.

Extrude: Extrudes a selected geometry along a given extrusion axis in a given exstruion distance. Loft: Generates a 3D surface by blending multiple profiles along a guiding path. Fill: Creates a surface that spans a closed boundary or set of edges. Sweep: Extends a profile along a predefined path to form a solid or surface. Blend: Smoothly transitions between two or more surfaces or edges. Assemble: Combines multiple components or features into a single structure. Fillet: Rounds the edges or corners of a geometry with a specified radius. Split: Divides a geometry into two parts using a cutting plane or surface. Trim: Removes portions of a geometry that extend beyond a specified boundary. Offset: Creates a new geometry parallel to the original at a specified distance. Extrapol: Extends an existing surface or curve beyond its current boundaries. Symmetry: Generates a mirrored copy of a geometry across a specified plane. Translate: Moves a geometry by a specified distance in a given direction. Boundary: Defines the outer limits of a geometry or surface. Extremum: Identifies the maximum or minimum points of a geometry. ExtremumPolar: Locates extreme points relative to a specific direction or axis. CurveSmooth: Refines a curve by reducing irregularities or sharp transitions. Near: Finds the closest point or feature relative to another geometry. AxisSystem: Defines a reference coordinate system with an origin and axes.

The inventors have for example tested successfully the method using in implementations the CAD features types of CATIA Generative Shape Design which correspond to the above set in CATIA, and which are: GSMLine, GSMCircle, GSMPlane, GSMPoint, GSMCurve, GSMIntersect, GSMProject, GSMCurvePar, GSMExtrude, GSMLoft, GSMFill, GSMSweep, GSMBlend, GSMAssemble, GSMFillet, GSMSplit, GSMTrim, GSMOffset, GSMExtrapol, GSMSymmetry, GSMTranslate, GSMBoundary, GSMExtremum, GSMExtremumPolar, GSMCurveSmooth, GSMNear, AxisSystem. Adaptations of the method to implementations with the corresponding CAD feature types of other CAD software solutions fall within the skills of the person skilled in the art.

Each node may further comprise node attributes describing geometrical features of the geometry created by the CAD feature represented by the node. The node attributes may be a vector (e.g. encoding vector) respective to the node and comprising data describing (encoding) the geometrical features (or properties) of the CAD features of the node listed in the below table:

| **Feature name** | **Feature type** | **Category number** | **Description** | **Encoding format** |
|---|---|---|---|---|
| Node ID | Integer | Number of nodes | Node ID reflecting the order of creation *and*selection of commands | Ordinal |
| Geometry | Categorical | 7 | Type of the geometry onto which the command is applied | Ordinal |
| IsMultiDomain | Binary | 2 | Number of objects processed by the command | Ordinal |
| Dimension | | 5 | Dimension of objects processed by the command | Embedding layer |
| IsClosed | Categorical | 3 | If the wireframe profile is closed | Ordinal |
| IsPlanar | | 3 | If the surface is planar | Ordinal |
| PlaneNormalX | | | | *l* |
| PlaneNormalY | Continue | *l* | Direction of the plane normal | *l* |
| PlaneNormalZ | | | | |

Each edge connects two nodes, and represents a parent-child relationship, in the respective CAD feature tree, between the CAD features represented by the two nodes. This means that one of the two nodes is the parent, and the other one the child, *i.e.* the parent node represents a CAD feature that is directly before the CAD feature represented by the child node in the feature tree. This means that, in the feature tree, there is a directed arrow/edge connecting the CAD feature represented by parent node to the CAD feature represented by the child node. In other words, in the CAD feature tree, the CAD feature represented by the child node is applied to the geometry resulting from the CAD feature represented by the parent node.

Each training example further comprises ground truth data. The ground truth data indicates the next CAD feature to predict according to one or more selected CAD features each corresponding to a node of the graph. In other words, each training example comprises data specifying one or more selected CAD features each corresponding to a respective node of the graph, and data specifying which is the label, among the labels of the set/list, of the next CAD feature to predict for these selected CAD features. These selected CAD features represent what a user would select during use (*e.g.* in the method of use) and the data specifying the label to predict represents what should be the correct next CAD feature prediction for such selection. The ground truth data may consist in a vector of size N, with N equal to the number of CAD feature types in the predetermined set of CAD features types. Each coordinate is thus respective to one type of CAD feature and comprises a value, the value indicating a ground truth probability that the CAD feature to predict is of this type. It is to be understood that, for some training examples, the vector may comprise one coordinate which corresponds to a probability of 1 (or 100%) with the other coordinate equal to zero, thus indicating with 100% certainty one only possible type of the next CAD feature. This may be the case for training examples for which the selected CAD feature(s) can only lead to one possible type of CAD features. For other training examples, the vector may comprise several non-zero coordinates as several CAD feature types are possible for the next CAD feature to predict. This is for example the case if the selected CAD feature(s) do not fully constrain the next CAD feature to be of one type, but may correspond to several possible next types, with varying probabilities. The forming of the training dataset discussed hereinbelow may comprise, for each training example, specifying this ground truth data, as further discussed hereinbelow.

The method may comprise (*e.g.* as part of the step of providing the training dataset) forming the training dataset. Forming the training dataset comprises providing an initial set of graphs. Each graph of the initial set represents a respective complete CAD feature tree and comprises nodes and edges each connecting two nodes. Each node represents a CAD feature of the respective complete CAD feature tree. Each node is labeled with a label from the predetermined set of labels. Each edge connects two nodes and represents a parent-child relationship, in the respective complete CAD feature tree, between the CAD features represented by the two nodes. Forming the training dataset then comprises, for each graph of the initial set, extracting subgraphs of the graph. Each extracted subgraph represents at least a part of the respective CAD feature tree represented by the graph. The subgraphs thereby extracted forming the training examples.

Providing the initial set of graphs may comprise providing a set of CAD feature trees, *i.e.* in a sufficient number (*e.g.* more than 40 trees, for example 43 in implementations) and diversity. Providing these CAD feature trees may comprise obtaining them (*e.g.* retrieving or downloading them) from a (*e.g.* distant/remote) database or server or memory where they have been stored further to their creation. Providing the initial set of graphs may then comprise converting each CAD feature tree into a JSON file. Providing the initial set may then comprise, for each JSON file, forming a graph of the initial set based on the JSON file. The graph thereby formed represents the respective CAD feature tree corresponding to the JSON file.

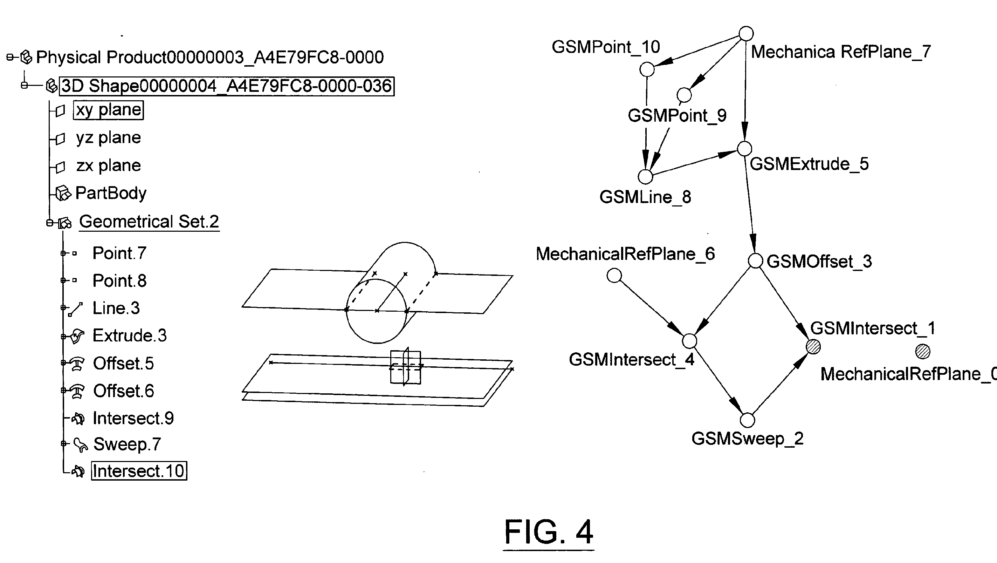

As known, JSON stands for "JavaScript Object Notation" and is an open standard file format and data interchange format that uses human-readable text to store and transmit data objects consisting of name-value pairs and arrays (or other serializable values). It is a commonly used data format with diverse uses in electronic data interchange, including that of web applications with servers. JSON is a language-independent data format. It was derived from JavaScript, but many modern programming languages include code to generate and parse JSON-format data. JSON filenames use the extension. Methods exist to read a CAD feature tree and extract a JSON file thereof, and the step of conversion of the CAD feature trees into JSON files may thus be performed by such method. FIG. 4 illustrates this step of conversion into JSON files and subsequent obtention of the graphs: left side shows the 3D model with its feature tree, and right side the corresponding graph. The nodes with hatching represent features selected by a user (in online/use phase), and the other nodes the features enabling the creation of these hatched nodes. The training example associated to this tree thus comprises data specifying the next CAD feature to predict based on the selected hatched nodes. For each JSON file resulting from the conversion step, forming the graph of the initial set which corresponds to that JSON file may comprise browsing/searching through the JSON file to retrieve the parent/child relationships, thereby creating the nodes and edges of the graph.

Providing the initial set of graphs may further comprise, in each graph of the initial set, removing (*i.e.* all) nodes corresponding to a CAD parameter, to a geometry not parameterized by a CAD feature, or a pure B-rep element. This step may be referred to as "Data Cleaning". A node corresponding to a CAD parameter is a node which corresponds to a feature which will modify the parameters of an existing CAD feature or a geometry resulting thereof, and such node is not considered to be a CAD feature *per se* and is thus removed: A node corresponding to a geometry not parameterized by a CAD feature is a node corresponding to a feature that is used to create geometry but is not a CAD feature *per se.* An example of such node is a "parameter node", which may exist in the feature tree to drive a value of a CAD parameter. A node corresponding to a pure B-rep element is a node that does not correspond to a CAD feature but to a sub-element of a CAD feature (or its corresponding geometry), typically created on the fly (an example of such node is the selection of a face of a surface). The Data Cleaning step thus removes unnecessary nodes. Elements such as BRep, unknown geometry, and parameters are removed, and so are their associated nodes. Specifically, BRep nodes are removed together with their siblings, and all their descendants. For parameter nodes, only the nodes themselves are removed. This removal is advantageous, especially for the BREP nodes as they do not correspond to any feature but to sub-element of it. In fact, as previously said BREP corresponds to a sub element (created on the fly) of an existing feature. (*e.g.* selecting a face of a surface). Using these objects as input could lead to instability, as they do not exist natively in the tree.

The Data Cleaning Step may also comprise discarding out-of-scope commands as Datum. The Datum type may correspond to a Default class (or default label) which means it does not correspond to any command to predict and to any command that to be considered as input. For example, if it corresponds to a command coming from another software application, it may be considered as Datum. By doing this process, the method still keeps relevant information from it (dimension, number of domain) and also preserves the graph architecture (relations between the objects).

Forming the training dataset then comprises, for each graph of the initial set, extracting subgraphs of the graph each representing at least a part of the respective CAD feature tree represented by the graph. The subgraphs thereby form the training examples. In this step, for each single graph of the initial set, the method creates multiple subgraphs: starting from each node in the graph of the initial set, the method forms several subgraphs by going up a maximal number of graph levels, *e.g.* maximum 10 levels. This step allows to augment data in the dataset, which improves robustness of the training. The subgraphs thereby created may have different depths, *i.e.* with a sufficient variability in depth.

Forming the training dataset may further comprise filtering out subgraphs comprising nodes representing CAD features of which number of occurrences in the training dataset is lower than a predefined threshold, for example lower than 24. This allows to remove from the training dataset CAD feature types which have too few samples for the function to learn to predict them. This results in that the labels in the training data all belong the predetermined set discussed above, which corresponds to the CAD feature having sufficient occurrences in the training data.

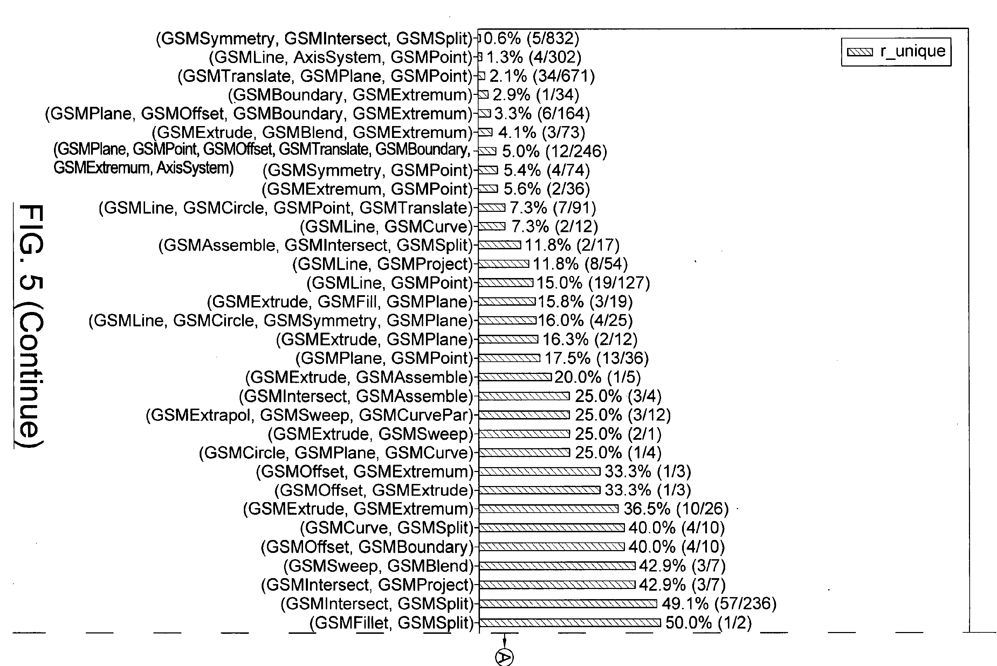

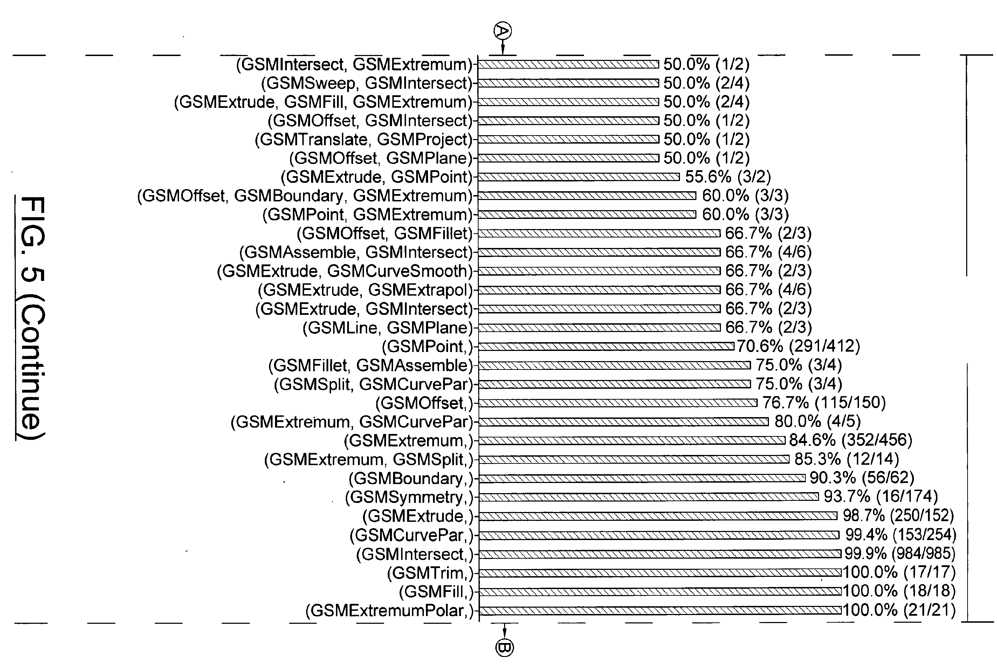

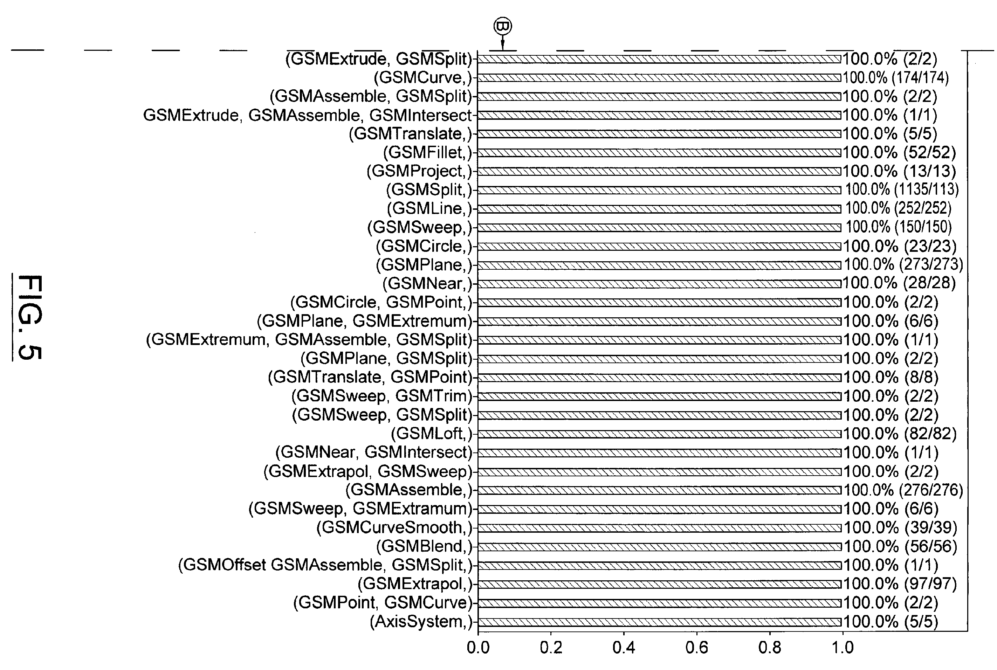

Forming the training dataset may further comprise identifying one or more groups each of topologically similar subgraphs. This means that graphs having the same topology and representing same sequences of CAD features, *i.e.* isomorphic and topologically similar graphs (in other words duplicate graphs), are identified by the method. This may be done by using any known method for identification of such duplicate graphs. Then, forming the training dataset may further comprise, for each group, selecting a subgraph representative of the group (*i.e*. one subgraph is selected among the duplicates) and labeling the selected subgraph with the labels of the other subgraphs of the group. Then, forming the training dataset may further comprise removing said other subgraphs. FIG. 5 illustrates a distribution of probabilities of these unique representatives over examples of sequences of CAD features, to illustrate the sequences which are more likely to occur and those which are less likely to occur.

Forming the training dataset may also comprise, for each training example, specifying the ground truth data for this training example, and which indicates a next CAD feature to predict according to one or more selected CAD features each corresponding to a node of the graph of this training example. This may be done by, for each subgraph, selecting an output node of the sub-graph (*i.e.* a leaf node), removing it from the subgraph (thus the subgraph without this node becomes the training example), and adding to the training example 1) data specifying the exact (ground truth) label of the output node and 2) data specifying the one or more selected CAD features (*i.e.* data specifying which parent node(s) of this output node are considered selected node for this training example).

Forming the training dataset may also comprise, for each training example, for each node of the graph of the training example, associating to the node its node attributes, which may be done after determination of these attributes. Forming the training dataset may also comprise labelling the nodes with all their labels.

Each training example may further comprise data describing a global architecture of the respective CAD feature tree, and which may be referred to as "global data". The global data is any data which describe globally the CAD feature tree so that the function can learn from not only local information (nodes and edges connections), but also from the global organization of the feature tree. The global data may include data describing one or more (*e.g.* all) of the following parameters: a number of CAD features in the respective CAD feature tree, a number of the one or more selected CAD features based on which the next CAD feature will be based, a dimension homogeneity of the one or more selected CAD features, and/or a number of different geometries of the respective CAD feature tree. The number of CAD features in the respective CAD feature tree is simply the count of the number of CAD features which are present in the tree, which helps the function to understand if the tree corresponds to a big or small CAD features sequence. The number of one or more selected CAD features based on which the next CAD feature will be based is the number of nodes which represent direct parents of the next CAD feature to predict and which are considered selected in the training example at stake. This helps the function to differentiate the type of command to predict as some of them may be strictly working with a specific number of inputs. The dimension homogeneity of the selected one or more CAD features is data quantifying a homogeneity of these selected CAD features in terms of dimensions. This data may be a binary value, with for example one possible value (*e.g.* 1) indicating dimension homogeneity and the other possible value (*e.g.* 0) indicating dimension inhomogeneity. The binary values allow the model to take decisions in terms of dimension homogeneity. This helps the function to understand that some commands can be used only if the selected inputs have the same dimensions. The number of different geometries of the respective CAD feature tree is data indicating a count of each geometry type that can be found in the feature tree (*e.g.* number of planes, points, circles, lines, curves, surfaces, solids, and volumes). This allows to identify the type of graph sequence currently designed. Forming the training dataset may comprise determining the global data for each training example and associating the determined global data to the training example.

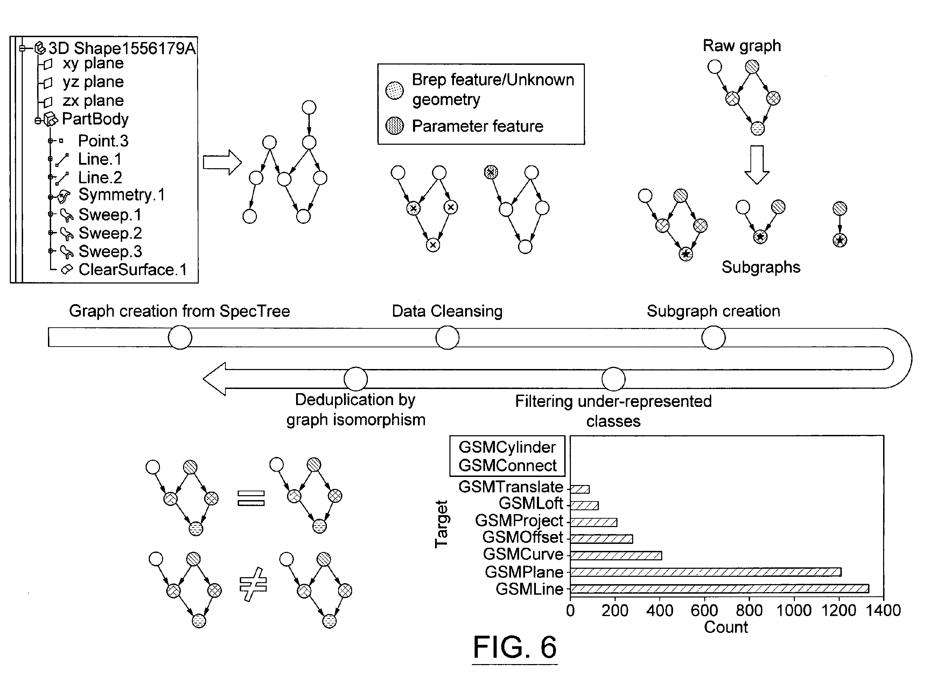

FIG. 6 illustrates an example of the process of forming the training dataset as discussed above.

It is to be understood that providing the training dataset may comprise or consist in the forming of the training dataset or at least a part thereof according to the above described process, but may also comprise simply obtaining (retrieving/downloading) the dataset or at least a part thereof from a (*e.g.* distant) memory or server or database on which the dataset has been stored further to its obtention according to the above discussed process for forming the dataset.

The method then comprises training the function based on the training dataset. The function is trained to take as input a graph representing at least a part of a CAD feature tree and to output a prediction of one or more next CAD features in the CAD feature tree. Each predicted next CAD feature belongs to the predetermined set of CAD features. The training comprises feeding to the function training examples. The function thus takes as input the graph of each training example and processes it, as well as the labels of its nodes. The function may also process the attributes of the nodes and the global data of the training example. Upon that processing, the function outputs the prediction of one or more CAD features for this training example. The function may for example output a vector of size N, with N equal to the number of CAD feature types in the predetermined set of CAD features types. Each coordinate is thus respective to one type of CAD feature and comprises a value, the value indicating a probability, determined by the function, that the CAD feature to predict is of this type. On the other hand, the training example also comprises the ground truth data discussed above. The training thus comprises, for each training example, quantifying a disparity between the output predicted by the function and the ground truth data, and adjusting the weights/parameters of the function as long as this disparity is not sufficiently small. This may be done by minimizing a loss, as known *per se* in the art of machine-learning. Any suitable loss may be used, this is a matter of implementation. For example, the method may use a common loss function used for regression problems, namely the Mean Squared Error (MSE), which measures the average squared difference between predicted and actual values. Alternatively, the Cross-Entropy Loss may be used, as it quantifies the difference between predicted probabilities and the true class labels.

The function may be a neural network.

The neural network comprises a Graph Neural Network (GNN) configured to take as input the input graph (*i.e.* the input to the function) representing at least a part of a CAD feature tree and to output an encoding of the input graph. The neural network also comprises a linear encoder configured to encode the data describing the global architecture in a global feature encoding. The neural network also comprises a fusion module configured to output a fusion encoding corresponding to a fusion of the global feature encoding and of the encoding of the input graph. The neural network also comprises a classifying module configured to take as input the fusion encoding and to output the prediction of the one or more next CAD features in the CAD feature tree.

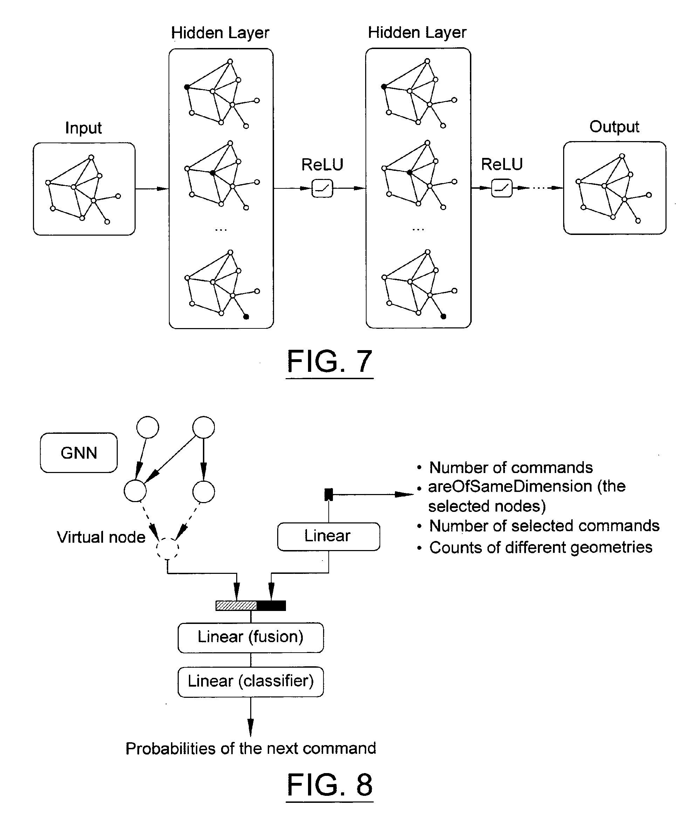

The method thus represents the data as graphs, which allows leveraging a Graph Neural Network that is well suited for the classification problem considered. Graph Neural Networks (GNNs) belong to a class of artificial neural networks designed to process and learn patterns from graph-structured data. GNNs perform neighborhood aggregation, updating node features by aggregating information from direct neighbors at each graph layer. This allows for information sharing as well as the capture of local context. FIG. 7 illustrates the GNN architecture.

The GNN of the function transforms and aggregates the data of the nodes (labels and nodes attributes) into an encoding of a virtual node, representing the next command (*i.e.* the next CAD feature to predict). The GNN may in implementations have a gated GNN architecture, which allows to advantage (give more weights) to the edges which are the closest to the selected CAD features. For each training example, the linear encoder (also referred to as linear layer) augments the global data, *i.e.* encodes it into the global feature encoding. Then, the encodings of the virtual node and the global features are merged by the fusion module which outputs the result of this merging as the fusion encoding. The classifying module is a linear layer that outputs the prediction of the one or more next CAD features based on the merged encodings.

FIG. 8 shows an illustration of the architecture of the function. Having these two types of information: the one on the left of FIG. 8 related to the nodes and their relations and the global feature helps the model to capture more information and the user intent which allows to robustly predict the right set of commands. Of course, having only the local information already provides interesting results, and the global features are adding additional information which is leading to better accuracy.

Further features of the learning/training of the function are now discussed.

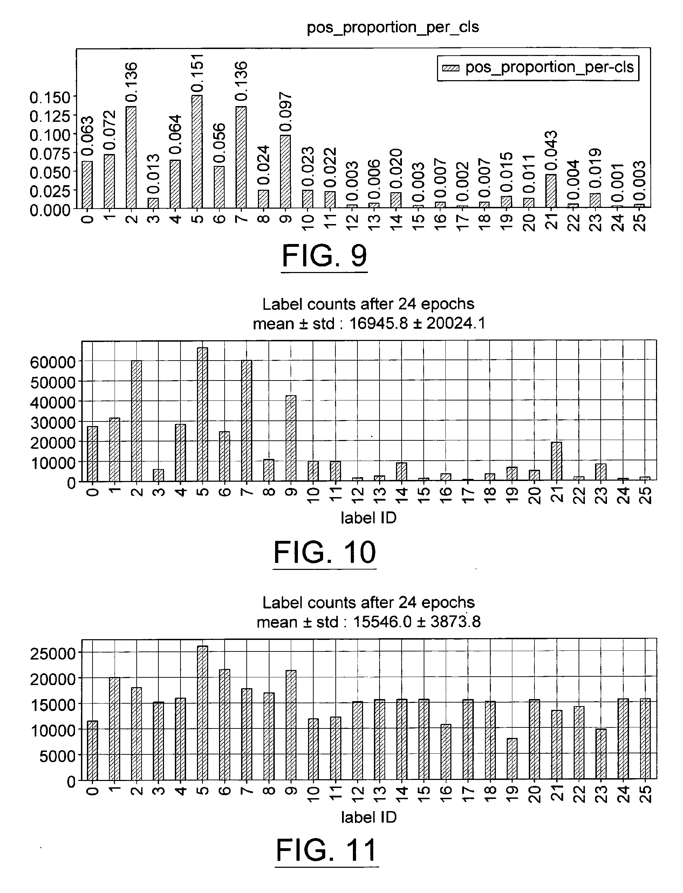

First of all, the distribution of classes (labels) in the dataset may be unbalanced. FIG. 9 illustrates an example implementation with unbalanced proportions of different classes. To solve this problem, the method may perform a weighted random sampling strategy during training. This consists in sampling instances of different classes/labels (*N.B.:* an instance of a label is a training example comprising that label) into batches using probabilities that are inversely proportional to the class proportions. In this way, instances of the majority class (*i.e.* graphs comprising a label of this class) will be down sampled, while those of the minority class (*i.e.* graphs comprising a label of this class) will be oversampled, achieving a balance of classes/labels. FIG.s 10 and 11 illustrate the effect of the weighted random sampler. FIG. 10 shows label counts after 24 epochs without weighted random sampling. FIG. 11 shows label counts after 24 epochs with weighted random sampling. The distribution of classes is much more balanced. These figures illustrate that distribution is much more balanced using this sampling strategy.

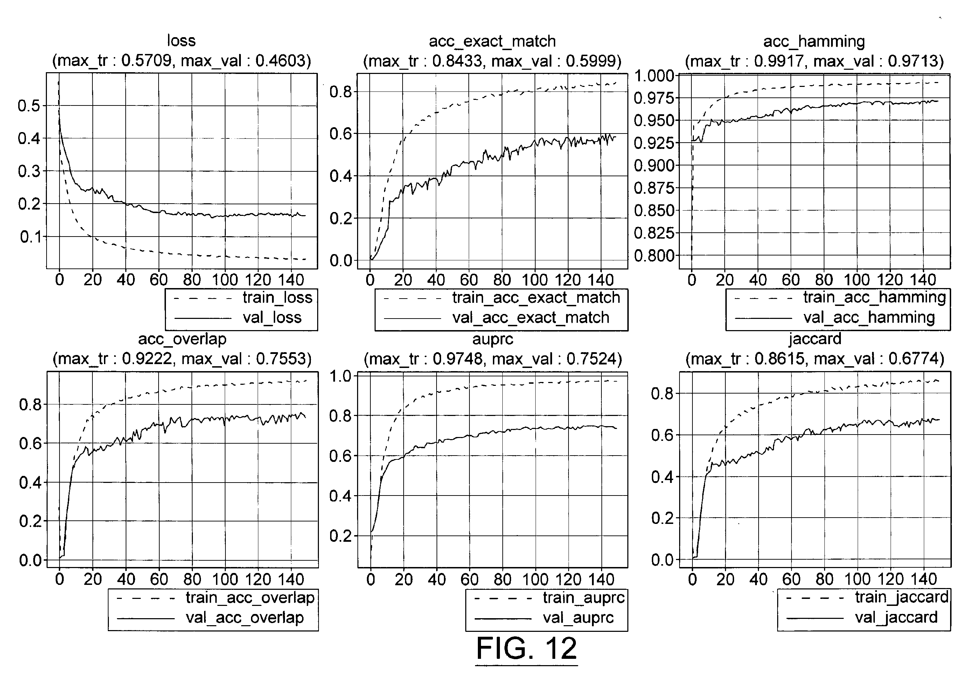

In implementations, after preprocessing 43 3D models for forming the training dataset with the pipeline mentioned above, the inventors obtained 7768 clean graphs. Different statistics are shown in FIG. 12. The following observations may be noted:
- The graphs are generally not large (on average 15.5 nodes and 18.8 edges), though their sizes vary significantly, with a similar standard deviation to the average;
- More than half (61.8%) of the graphs only have one label, though 3% of the graphs can have up to 8 labels that should be predicted from the datum input;
- The distribution of classes is far from balanced, with GSMSplit, GSMIntersect, and GSMPoint being the top three majority classes.

In overall, one can see that in these implementations the function is learning in a pretty fast manner the different design pattern and shows good results.

Regarding evaluation of the training results, the method aims at solving a multi-class prediction problem, and at providing multiple good solutions for a prediction. The inventors thus used different types of metrics in order to validate the model accuracy. The table below represents the results with these different metrics.

| **Metrics Name** | **Value** | **Explanation of different Accuracies** |
|---|---|---|
| Accuracy (Hamming) | 94.7% | The proportion of labels correctly predicted out of all the labels. For example, below, it is 4/9=44% |
| Accuracy (Overlap) | 75.5% | The prediction will be considered as a correct prediction because the 1s in ground truth overlaps with |
| Accuracy (Exact Match) | 59.0% | All prediction match with a correct label |
| F1 Score | 74.4% | |

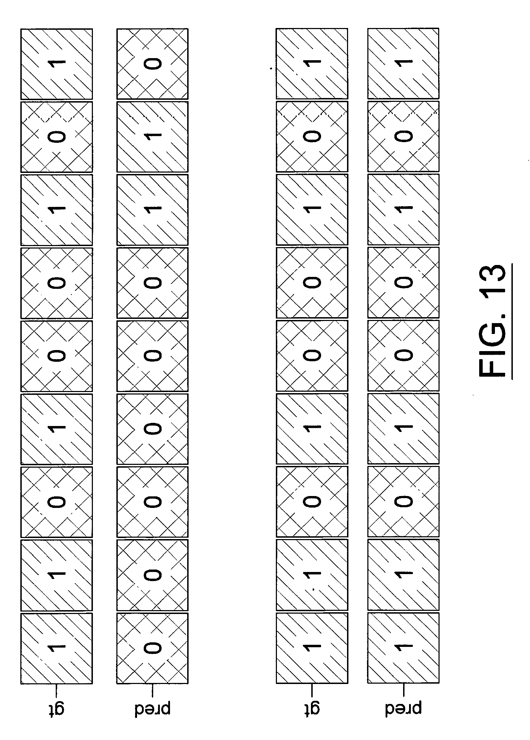

FIG. 13 illustrates a comparison between the ground truth (gt) and the prediction (pred) for the second metric (top part of the figure) and third metric (bottom part of the figure), to illustrate the above explanation of different accuracies.

As previously explained, the function is configured to output predictions of one or more next CAD features for the input feature tree. The function may further comprise a module configured to filter out these predictions and only keep the more relevant ones, *i.e*. the M predictions having the largest probability values, with M an integer larger than or equal to 1, 2, 3, 4 or 5 and/or the prediction having a probability value larger than a predefined threshold (*e.g.* the threshold may equal 0.5, 0.6, 0.7, 0.8 or 0.9). The function may further comprise a module configured to display, on a display of the underlying computer system (*e.g.* a GUI of an underlying CAD system), graphical icons each representing a respective symbol of a respective one of the predicted CAD features. The icons may be displayed next to each other, e.g. in a line or in a circle. Each icon may be configured to, upon a user moving a cursor of a haptic device (*e.g.* a mouse) over the icon, display the name of the CAD feature corresponding to this icon. The module which displays the icon may be further configured to, upon the user graphically selecting (*e.g.* clicking on) the icon, add the corresponding CAD feature tree as a child of the CAD feature(s) previously selected by the user (right before application of the function), and display (*e.g.* as a widget, as currently done in existing CAD software solutions) the editable parameters, specifications and properties of the CAD feature (*e.g.* extrusion direction and length for an extrusion feature). Upon the user selecting the feature (or rather its icon) and editing the parameters and specifications, the module fully integrates the new CAD feature to the feature tree, and the display of the corresponding object may be updated accordingly by the system executing the feature tree. The function may also comprise a pre-processing module configured to, based on the feature tree to be inputted to the function, on which the user has selected one or more CAD features, convert the feature tree and the selection of one or more CAD features into the graph, associated global data and nodes attributes as discussed above for the training examples (but, of course, without ground truth), to be then inputted to the function, or rather to its neural network part. The pre-processing may perform this only for a sub-feature tree of the feature tree, *i.e.* it selects the 5 parent generations of all the selected CAD features (*e.g.* those selected by the user in the method of use) and computes the corresponding graph, node attributes and global data only for the sub-feature tree that is formed by the selected features and their 5 parent generations. This number of parent generations may be a hyperparameter of the function and may thus be edited. All these modules are deterministic and thus may not be part of the training, with only the neural network part of the function being trained.

The method of use is now further discussed.

The method of use comprises one or more iterations.

Each iteration comprises providing a CAD feature tree. The provided CAD feature tree is a feature tree being designed by a user. If the iteration is the first iteration, the CAD feature tree may consist in a single initial geometry already created by the user. If the iteration is a subsequent iteration, the CAD feature tree already comprises one or more CAD features (at least two is this is the second iteration or following). In any case, providing the CAD feature tree may comprise displaying the CAD feature as known per se in conventional CAD solutions (as in CATIA), with for example the sub-trees in the feature tree being displayed only when the user selects their roots/initial nodes, and/or displaying the geometry that results from the execution of the feature tree.

The iteration further comprises, by a user, graphically selecting one or more CAD features in the CAD feature tree or one or more geometries created from the one or more CAD features. The user may for example graphically select one or more geometries (*e.g.* by a click or touch on the geometries/geometry) of the model that currently results from the execution of the feature tree, this model being displayed on a display of the computer (*e.g.* a dedicated GUI of a CAD system). Alternatively, the user may graphically select (*e.g.* by click or touch) the CAD features directly on the feature tree, which may be displayed on the same screen as the visual representation model that results from execution of the feature tree. The system may display a visual indication of the features that have been selected, to provide visual feedback to the user. For example, these features may be highlighted in the feature tree and/or their corresponding geometries may be highlighted in the visual representation of the model that results from execution of the feature tree.

The iteration then further comprises, by using the function, predicting one or more next CAD features to add to the CAD feature tree based on the user selection. This may be done automatically by the system: the user's selection of CAD features automatically triggers the application of the function. As explained above, a pre-processing module of the function may automatically determine the graph of the feature tree, compute the nodes attributes, and the global data associated with the feature tree, and then the neural network part of the function computes the predictions of one or more next CAD features to add in the tree. The method may further comprise, *e.g.* by automatic execution of modules of the function discussed above, displaying graphical representations of the predicted one or more CAD feature to the user. For example, one icon may be displayed per predicted CAD feature, and all the icons may be displayed together as a line or circle. Upon the user moving a cursor of the computer's mouse or touch sensitive haptic device over an icon, the system may display the name of the CAD feature associated with that icon. The system may also additionally display, *e.g.* next to the icon, the probability associated with that feature as predicted may also be displayed, such that the user may see which prediction has the more confidence.

The iteration then further comprises, by the user, selecting a predicted CAD feature by graphically selecting (*e.g.* click or touch) the displayed graphical representation (*e.g.* icon) of the predicted CAD feature, thereby adding the CAD feature to the CAD feature tree. Indeed, upon selection of the feature, the system (*e.g.* by execution of a previously discussed module of the function) automatically adds the feature to the feature tree. The system may, when the CAD feature is added to the tree, display to the user a widget allowing the user to set and select the parameters and specifications of the feature, as conventionally done in existing CAD systems. The system may then execute the updated feature tree to update the visual representation of the model. If there is more than one iteration, which is normally the case when designing a feature tree, at each iteration, the CAD feature tree to which the user-selected CAD feature is added forms the provided CAD feature tree of the next iteration.

An example illustration of the method of use is now discussed with reference to FIG.s 14 to 25.

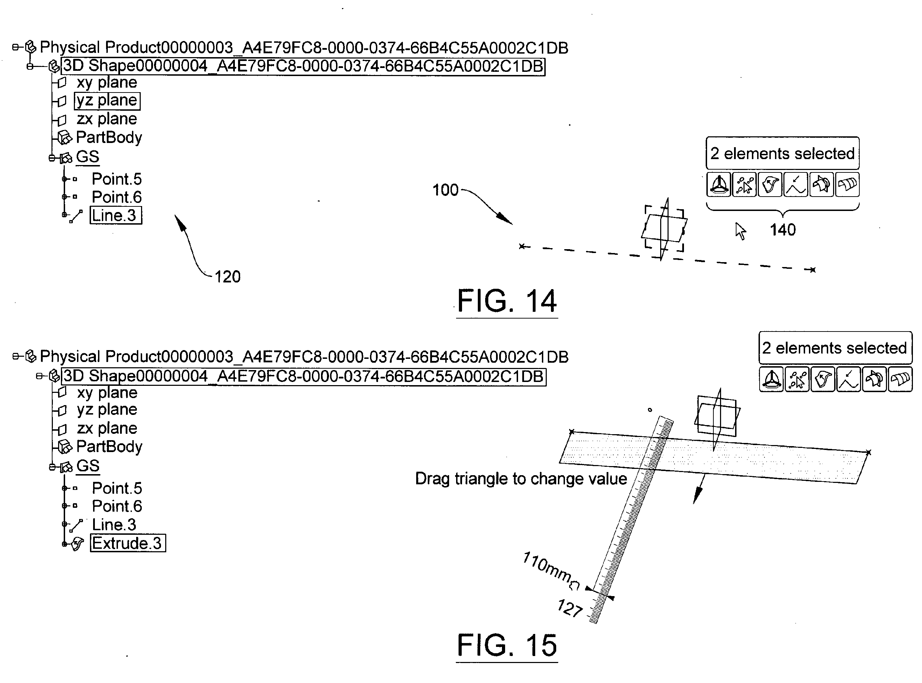

FIG. 14 shows a CAD model 100 and its feature tree 120 displayed on a GUI of a CAD system at an early stage of the design of the feature tree. The user has selected two geometries, a square and a line, and the selected geometries and their features in the feature tree are highlighted to provide visual feedback of the selection. This triggers automatic application of the function. The list of the plausible next CAD features predicted by the function is then displayed as a line 140 of visual icons representing these features. The user clicks on the icon that corresponds to the Extrude CAD feature type.

FIG. 15 shows the Extrude type having been selected by the user and a graphical widget being displayed to allow the user to set the extrusion distance, to extrude the selected line in the direction orthogonal to the plane defined by the selected square.

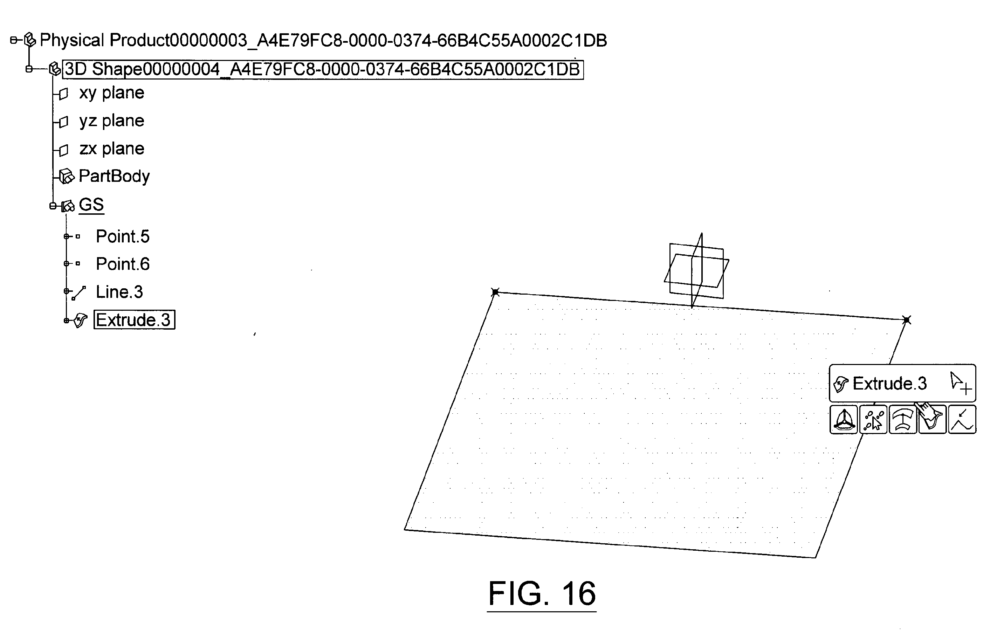

FIG. 16 shows the result of the Extrude feature, and this result being selected by the user in the next iteration (the geometry resulting from the Extrude and its name in the feature tree are highlighted to provide visual feedback of the selection). This selection again triggers automatic application of the function and the subsequent display of the icons representing the features predicted by the function.

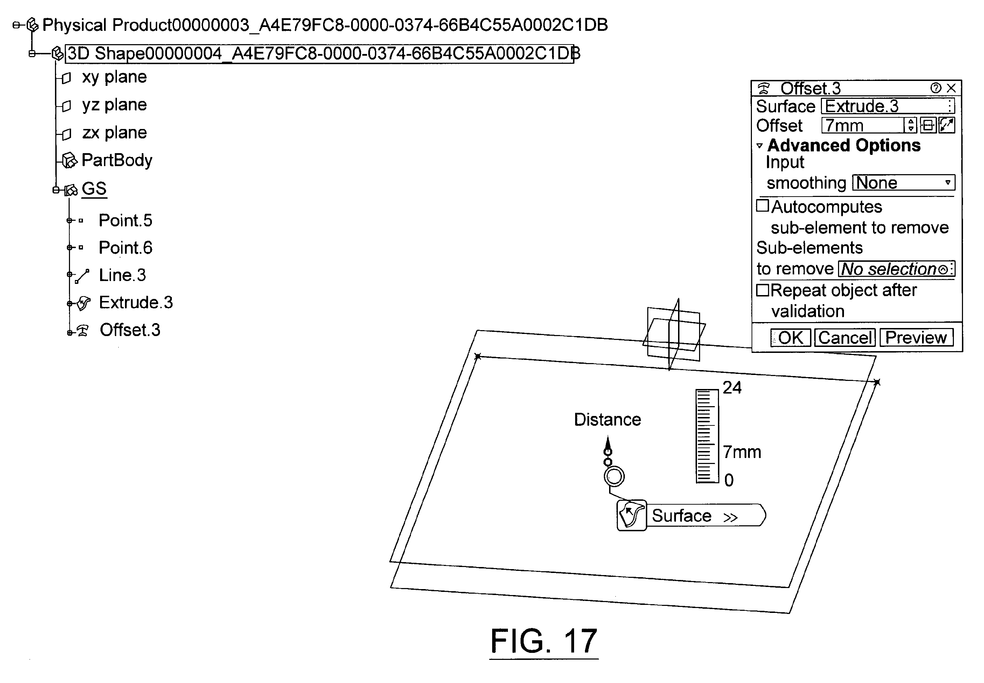

FIG. 17 shows that the user has selected the offset type among the predictions of the function and a widget is displayed to allow the user to set the parameters and specifications of the Offset feature.

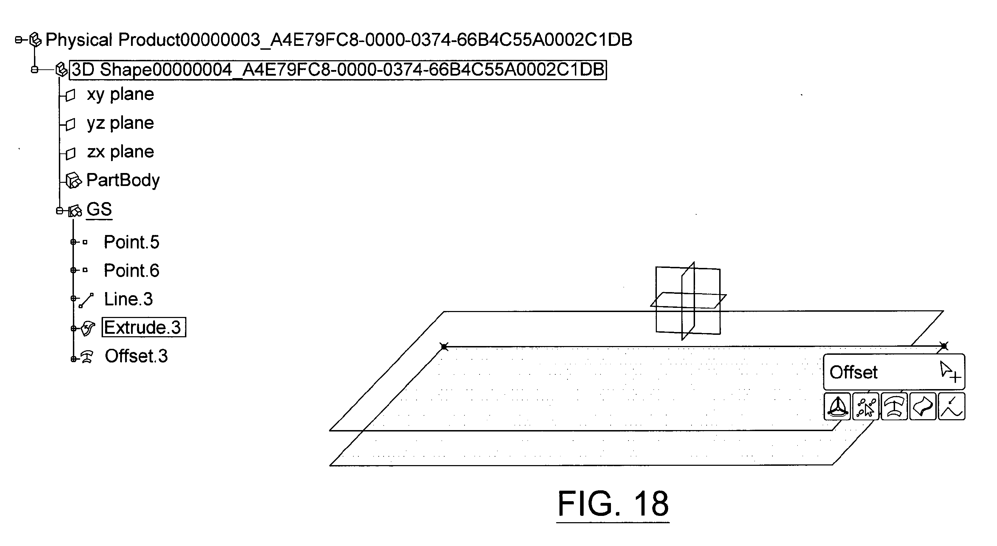

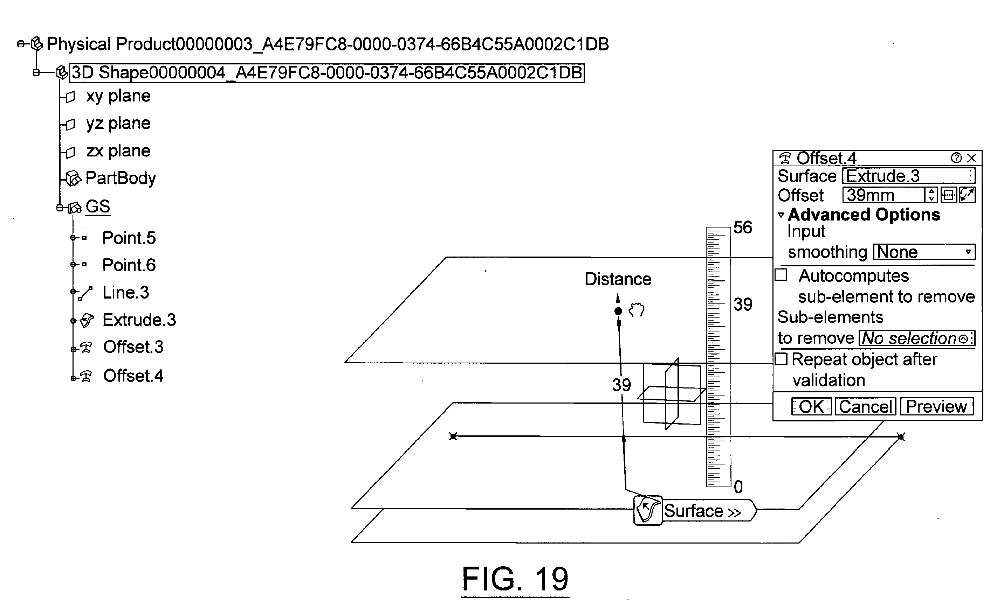

FIG. 18 shows the result of the Offset, and also that the user as selected again, in the next iteration, the Extrude feature created in FIG.s 15-16. The function again provides automatically its predictions, and the user selects again the Offset type, and defines yet another Offset as shown in FIG. 19.

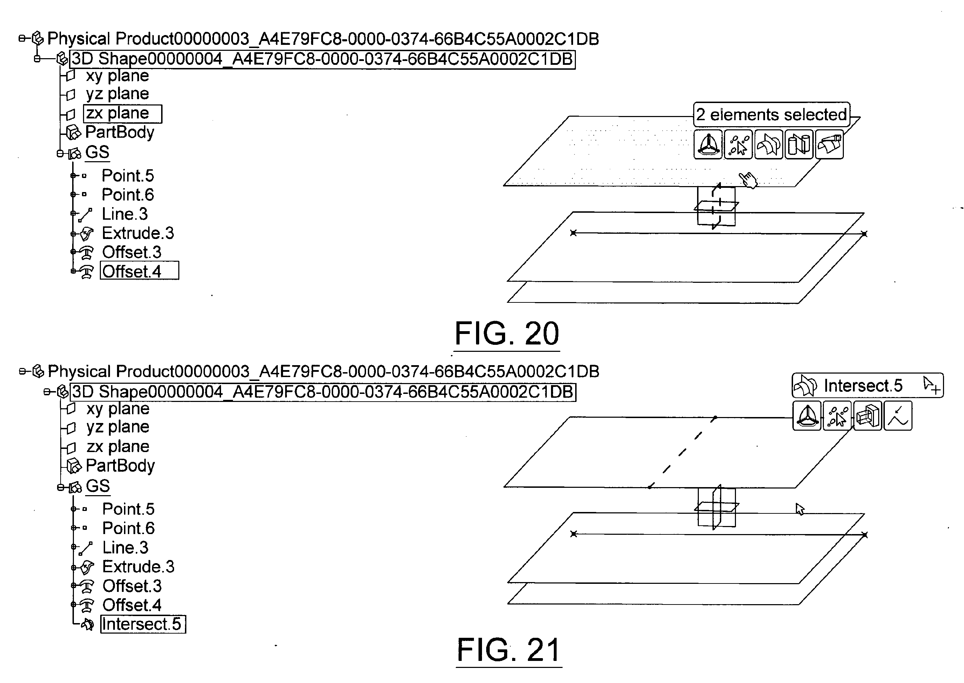

On FIG. 20, it is shown that in the next iteration, the user has selected a square geometry and the result of one of the Offset features, as shown with highlights in the figure. The function again provides automatically several predictions, and the user selects the Intersect feature type, as shown in FIG. 21.

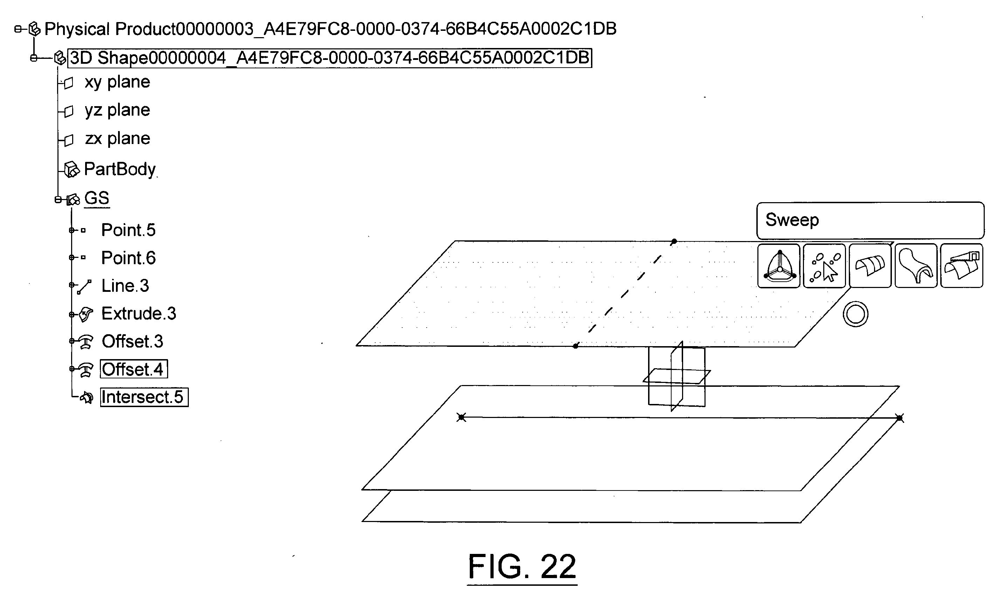

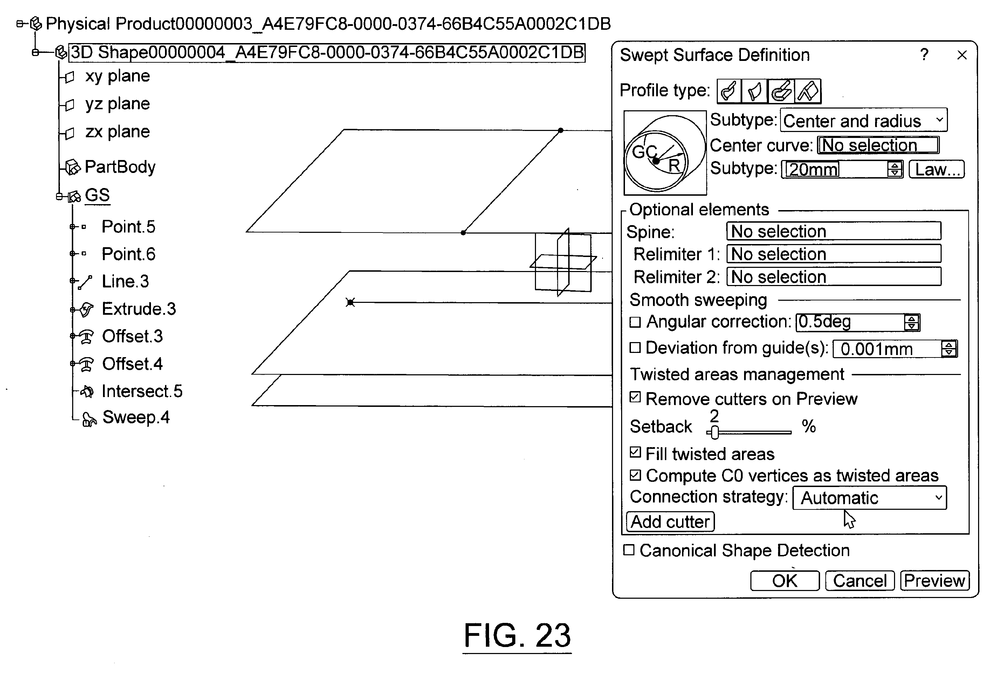

On FIG. 22, the user has selected, in the next iteration, the results of the Intersect feature and the result of an Offset feature. The function again provides automatically several predictions, and the user selects the Sweep feature type, as shown in FIG. 23 which also shows the display of a graphical widget to set the specifications of the Sweep.

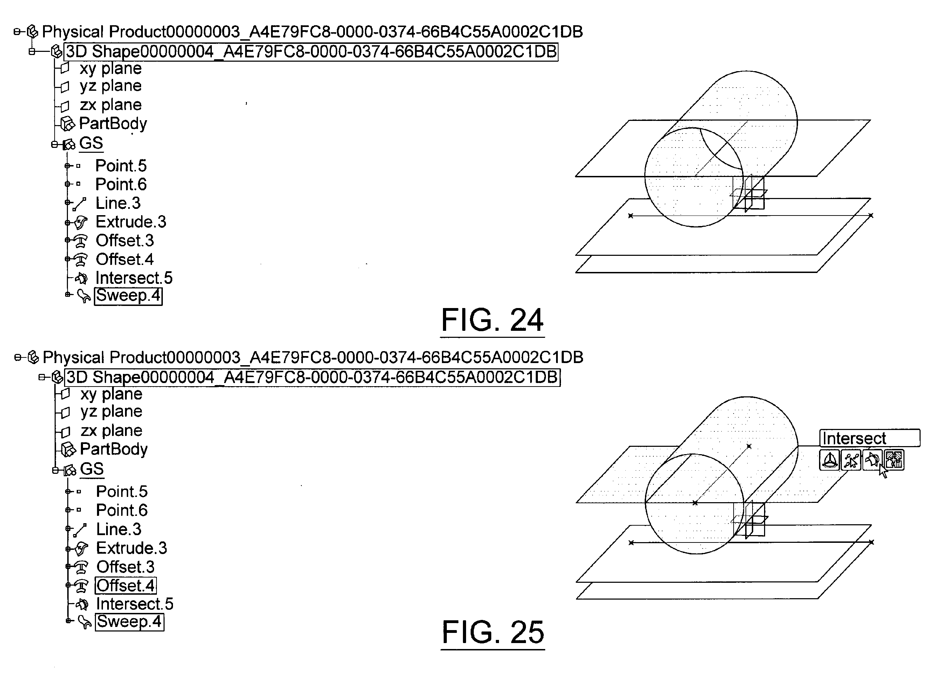

FIG. 24 shows the result of the Sweep and its selection by the user in the next iteration, as well as the selection of an Offset feature. The function again provides automatically several predictions, and the user selects the Intersect feature type, as shown in FIG. 25.

FIG.s 14 to 25 illustrate only some iterations within a bigger CAD feature tree design sequence that comprise more iterations and that ultimately results in a complete CAD model representing a manufacturable mechanical part. In other words, the method of use may be executed (*i.e.* the iterations are repeated) until a complete CAD model representing a manufacturable mechanical part is obtained. Nevertheless, these figures already illustrate the ergonomic advantage provided by the proposed methods: each time a user selects a geometry or geometries to add a new CAD feature, the user has only to select the next CAD feature among a limited list of possible choices (only 5 choices in the figure), instead of having to go through a complex menu as illustrated for example in FIG. 1. Eye fatigue of the user is thus objectively decreased, as well as the number of user-machine interactions (*e.g.* clicks or touches) required for the selection of a feature (no need to browse through a complex menu). Once a feature is selected, the setting of its parameters and specifications is done conventionally with a widget similar or identical to existing ones of current CAD solutions (*e.g.* CATIA), and thus does not bring any ergonomical advantage or reduction of the number of clicks. These advantages are however objectively brought by the method at each selection of a new feature.

The learning method and the method of use may be integrated into a same computer-implemented process, which comprises performing the method and then the method of use. The method of use or this process that integrates both methods may be part of a design and manufacturing process, where the method of use is executed until obtention of a complete CAD model representing a manufacturable mechanical part. The design and manufacturing process may then comprise using the CAD model to manufacture the part. Using the CAD model to manufacture the part may comprise one or more of the following:
- storing the CAD model as CAD specifications, for example in a data file (*e.g.* a CAD file) or as distributed data available on one or more storage, convertible into manufacturing instructions to control and/or set the manufacturing process and/or machinery for manufacturing the mechanical part;
- converting the CAD specification or the CAD model into CAM specifications, for example stored as CAM file or alternatively as CAM distributed data to control and/or set the manufacturing process and/or machinery for manufacturing the mechanical part;
- manufacturing the mechanical part based on the CAD model/specifications or the CAM specifications.

"Designing a manufacturing product/mechanical part/mechanical product" designates any action or series of actions which is at least a part of a process of elaborating a modeled object (3D or 2D) of the manufacturing product/mechanical part/mechanical product. The method of use may thus form such a process or may form at least a part of the process as discussed above.

The methods thus generally manipulate modeled objects, such as the feature trees and/or or their (B-reps) visual representations as discussed above. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD, CAE, PLM and/or CAM system, as will be apparent from the definitions of such systems provided below.

By CAD solution (*e.g.* a CAD system or a CAD software), it is additionally meant any system, software or hardware, adapted at least for designing a modeled object on the basis of a graphical representation of the modeled object and/or on a structured representation thereof (*e.g.* a feature tree), such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts. The specifications (also referred to as "CAD specifications) of a CAD model may be stored in a CAD file as explained above, but may also be stored as distributed CAD data on one or more storage, *i.e.* on a cloud environment.

In the context of CAD, a modeled object may typically be a 2D or 3D modeled object, e.g. representing a product such as a part or an assembly of parts, or possibly an assembly of products. The 2D or 3D modeled object may be a manufacturing product, *i.e.* a product to be manufactured. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 2D or 3D modeled object may represent the geometry of a product to be manufactured in the real world subsequent to the completion of its virtual design with for instance a CAD/CAE software solution or CAD/CAE system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD/CAE software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolute, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By PLM system, it is additionally meant any system adapted for the management of a modeled object representing a physical manufactured product (or product to be manufactured). In a PLM system, a modeled object is thus defined by data suitable for the manufacturing of a physical object. These may typically be dimension values and/or tolerance values. For a correct manufacturing of an object, it is indeed better to have such values.

By CAE solution, it is additionally meant any solution, software of hardware, adapted for the analysis of the physical behavior of a modeled object. A well-known and widely used CAE technique is the Finite Element Model (FEM) which is equivalently referred to as CAE model hereinafter. An FEM typically involves a division of a modeled object into elements, i.e., a finite element mesh, which physical behaviors can be computed and simulated through equations. Such CAE solutions are provided by Dassault Systemes under the trademark SIMULIA^{®}. Another growing CAE technique involves the modeling and analysis of complex systems composed a plurality of components from different fields of physics without CAD geometry data. CAE solutions allow the simulation and thus the optimization, the improvement and the validation of products to manufacture. Such CAE solutions are provided by Dassault Systemes under the trademark DYMOLA^{®}. CAE may be used to ensure that various structural requirements (such as, but not limited to, mass, stiffness, strength, durability) are achieved by a new CAD model. Some of these requirements may be called Key Performance Indicators (KPIs). For many industrial products (for example cars, airplanes, consumer packaged goods, hi-tech), these KPIs are in conflict *e.g.* lower mass usually causes lower stiffness. Thus, optimization methods are often applied to find the best trade-off between the KPIs.

By CAM solution, it is meant any solution, software of hardware, adapted for managing the manufacturing data of a product. The manufacturing data generally include data related to the product to manufacture, the manufacturing process and the required resources. A CAM solution is used to plan and optimize the whole manufacturing process of a product. For instance, it may provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. For example, a CAM solution may provide the information regarding machining parameters, or molding parameters coherent with a provided extrusion feature in a CAD model. Such CAM solutions are provided by Dassault Systèmes under the trademarks CATIA, Solidworks or trademark DELMIA^{®}.

CAD and CAM solutions are therefore tightly related. Indeed, a CAD solution focuses on the design of a product or part and CAM solution focuses on how to make it. Designing a CAD model is a first step towards a computer-aided manufacturing. Indeed, CAD solutions provide key functionalities, such as feature based modeling and boundary representation (B-Rep), to reduce the risk of errors and the loss of precision during the manufacturing process handled with a CAM solution. Indeed, a CAD model is intended to be manufactured. Therefore, it is a virtual twin, also called digital twin, of an object to be manufactured with two objectives:
- checking the correct behavior of the object to be manufactured in a specific environment; and
- ensuring the manufacturability of the object to be manufactured.

PDM stands for Product Data Management. By PDM solution, it is meant any solution, software of hardware, adapted for managing all types of data related to a particular product. A PDM solution may be used by all actors involved in the lifecycle of a product: primarily engineers but also including project managers, finance people, sales people and buyers. A PDM solution is generally based on a product-oriented database. It allows the actors to share consistent data on their products and therefore prevents actors from using divergent data. Such PDM solutions are provided by Dassault Systemes under the trademark ENOVIA^{®}.

Any modeled object involved in the methods may be a CAD model, comprising or consisting in a feature tree, and optionally its B-rep. Such a model may stem from a CAE model and may result from a CAE to CAD conversion process, that the method may for example comprise at an initial stage.

Any CAD model herein is feature-based (it comprises a feature tree, and optionally a corresponding B-rep obtained by executing the feature tree). A feature-based 3D model allows (*e.g.* during the determination of a manufacturing file or CAM file or CAM specifications stored as distributed data as discussed hereinafter) the detection and an automatic resolution of a geometry error in a CAD model such as a clash that will affect the manufacturing process. A clash is an interpenetration between two parts of a 3D model for example due to their relative motion. Furthermore, this clash may sometimes only be detected via a finite element analysis based on the CAD feature-based model. Therefore, a resolution of a clash can be performed with or automatically by the CAD solution by iteratively modifying the parameters of the features and doing a finite element analysis.

As another example, a feature-based 3D model allows (*e.g.* during the determination of a manufacturing file or CAM file or CAM specifications stored as distributed data as discussed hereinafter) an automatic creation of a toolpath for a machine via a computer numerical control (CNC). With CNC, each object to be manufactured gets a custom computer program, stored in and executed by the machine control unit, a microcomputer attached to the machine. The program contains the instructions and parameters the machine tool will follow. Mills, lathes, routers, grinders and lasers are examples of common machine tools whose operations can be automated with CNC.

A key characteristic of a CAD model is that it may be designed exactly and unambiguously by chaining a small number of high-level parameterized design operations (including for example, but not limited to, sketch, extrusion, chamfer) and edited by modifying its high-level parameters. That this is a key distinction with the polyhedral representations such as a triangular surface mesh which may represent any 3D shape but do not provide modification or parameterization capabilities required in an industrial design context.

As CAD model is a parameterized model of a part/product, it is lighter in terms of memory footprint than other models such as a CAE model. Indeed, instead of storing a collection of discrete geometrical elements such as finite elements, a CAD model allows the storing of a list of features and parameters, which is lighter in terms of storage and memory footprint. Working on CAD models thus reduced memory requirements for the underlying systems, as compared for example to CAE models, in addition to facilitate editability of the model. This amounts to say that a CAE to CAD conversion process in fact compresses the CAE model into a CAD model which is lighter in terms of memory requirements (*e.g.* footprint), in addition to transforming the CAE model into a more easily editable CAD model.

The generation of a custom computer program from CAD files or CAD distributed specifications may be automated. Such generation may therefore be errorproof and may ensure a perfect reproduction of the CAD model to a manufactured product. CNC is considered to provide more precision, complexity and repeatability than is possible with manual machining. Other benefits include greater accuracy, speed and flexibility, as well as capabilities such as contour machining, which allows milling of contoured shapes, including those produced in 3D designs.

The B-rep (i.e. boundary representation) is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep doesn't contain any history-based information.

The methods may be included in a production/manufacturing process as discussed hereinafter, which may comprise, after performing the methods, producing a physical product corresponding to the modeled object designed by the methods, and notably the method of use. The production process may comprise the following steps:
- (*e.g.* automatically) applying the methods or the method of use, thereby obtaining the CAD model outputted by the method of use as discussed above;
- using the obtained CAD model for manufacturing the part/product.

Using a CAD model for manufacturing designates any real-world action or series of action that is/are involved in/participate to the manufacturing of the product/part represented by the CAD model. Using the CAD model for manufacturing may for example comprise one or more of the following steps:
- editing the obtained CAD model;
- performing simulation(s) based on the CAD model or on a corresponding CAE model (*e.g.* the CAE model from which the CAD model stems, after a CAE to CAD conversion process), such as simulations for validation of mechanical, use and/or manufacturing properties and/or constraints (*e.g.* structural simulations, thermodynamics simulation, aerodynamic simulations);
- editing the CAD model based on the results of the simulation(s);
- optionally (*i.e.* depending on the manufacturing process used, the production of the mechanical product may or may not comprise this step), (*e.g.* automatically) determining manufacturing specifications/CAM specifications (*e.g.* stored as a manufacturing file/CAM file or as distributed CAM data stored on one or more storage (*e.g.* comprising manufacturing instructions for manufacturing the product represented by the CAD model and/or control instructions for the manufacturing process and/or for commanding the manufacturing process or manufacturing tool(s) thereof)) based on the (*e.g.* edited) CAD model (*e.g.* the control instructions stem from the CAD file or distributed CAD data storing the CAD model and/or specifications of the CAD model), for production/manufacturing of the manufacturing product;
- sending the CAD specifications and/or the manufacturing specifications/CAM specifications to a factory in view of manufacturing the product represented by the CAD model; and/or
- (*e.g.* automatically) producing/manufacturing, based on the determined manufacturing specifications/CAM specifications or on the CAD model, the mechanical product originally represented by the model outputted by the method. This may include feeding (*e.g.* automatically) the manufacturing specifications/CAM specifications and/or the CAD specifications to the machine(s) performing the manufacturing process.

This last step of production/manufacturing may be referred to as the manufacturing step or production step. This step manufactures/fabricates the part/product based on the CAD model and/or the CAM specifications, e.g. upon the CAD model and/or CAD specifications being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps. Because the design method improves the design of a model (CAE or CAD) representing the part/product, the manufacturing and its productivity are also improved.

Editing the CAD model may comprise, by a user (*i.e.* a designer), performing one or more editions of the CAD model, *e.g.* by using a CAD solution. The modifications of the CAD model may include one or more modifications each of a geometry and/or of a parameter of the CAD model. The modifications may include any modification or series of modifications performed on a feature tree of the model (*e.g.* modification of feature parameters and/or specifications) and/or modifications performed on a displayed representation of the CAD model (*e.g.* a B-rep). The modifications are modifications which maintain the technical functionalities of the part/product, *i.e.* the user performs modifications which may affect the geometry and/or parameters of the model but only with the purpose of making the CAD model technically more compliant with the downstream use and/or manufacturing of the part/product. Such modifications may include any modification or series of modification that make the CAD model technically compliant with specifications of the machine(s) used in the downstream manufacturing process. Such modifications may additionally or alternatively include any modification or series of modification that make the CAD model technically compliant with a further use of the product/part once manufactured, such modification or series of modifications being for example based on results of the simulation(s).

The CAM specifications may comprise a manufacturing set up model obtained from the CAD model. The manufacturing set up may comprise all data required for manufacturing the mechanical product (*e.g.* control instructions for controlling the manufacturing process) so that it has a geometry and/or a distribution of material that corresponds to what is captured by the CAD model, possibly up to manufacturing tolerance errors. Determining the production specifications may comprise applying any CAM (Computer-Aided Manufacturing) or CAD-to-CAM solution for (*e.g.* automatically) determining the production specifications from the CAD model (*e.g.* any automated CAD-to-CAM conversion algorithm). Such CAM or CAD-to-CAM solutions may include one or more of the following software solutions, which enable automatic generation of manufacturing instructions and tool paths for a given manufacturing process based on a CAD model of the product to manufacture:
- Fusion 360,
- FreeCAD,
- CATIA,
- SOLIDWORKS,
- The NC Shop Floor programmer of Dassault Systèmes illustrated on https://my.3dexperience.3ds.com/welcome/fr/compass-world/rootroles/nc-shop-floor-programmer,
- The NC Mill-Turn Machine Programmer of Dassault Systemes illustrated on https://my.3dexperience.3ds.com/welcome/fr/compass-world/rootroles/nc-mill-turn-machine-programmer, and/or
- The Powder Bed Machine Programmer of Dassault Systemes illustrated on https://my.3dexperience.3ds.com/welcome/fr/compass-world/rootroles/powder-bed-machine-programmer.

The product/part may be an additive manufacturable part, *i.e.* a part to be manufactured by additive manufacturing (*i.e.* 3D printing). In this case, the production process does not comprise the step of determining the CAM specifications and directly proceeds to the producing/manufacturing step, by directly (*e.g.* and automatically) feeding a 3D printer with the CAD model. 3D printers are configured for, upon being fed with a CAD model representing a mechanical product (*e.g.* and upon launching, by a 3D printer operator, the 3D printing), directly and automatically 3D print the mechanical product in accordance with the CAD model. In other words, the 3D printer receive the CAD model, which is (*e.g.* automatically) fed to it, reads *(e.g.* automatically) the CAD model, and prints (*e.g.* automatically) the part by adding together material, *e.g.* layer by layer, to reproduce the geometry and/or distribution of material captured by the CAD model. The 3D printer adds the material to thereby reproduce exactly in reality the geometry and/or distribution of material captured by the CAD model, up to the resolution of the 3D printer, and optionally with or without tolerance errors and/or manufacturing corrections. The manufacturing may comprise, *e.g.* by a user (*e.g.* an operator of the 3D printer) or automatically (by the 3D printer or a computer system controlling it), determining such manufacturing corrections and/or tolerance errors, for example by modifying the CAD specifications to match specifications of the 3D printer. The production process may additionally or alternatively comprise determining (*e.g.* automatically by the 3D printer or a computer system controlling it) from the CAD model, a printing direction, for example to minimize overhang volume (as described in European patent No. 3327593, which is incorporated herein by reference), a layer-slicing (i.e., determining thickness of each layer, and layer-wise paths/trajectories and other characteristics for the 3D printer head (e.g., for a laser beam, for example the path, speed, intensity/temperature, and other parameters).

The product/part may alternatively be a machined part (*i.e.* a part manufactured by machining), such as a milled part (*i.e.* a part manufactured by milling). In such a case, the production process may comprise a step of determining the CAM specifications. This step may be carried out automatically, by any suitable CAM solution to automatically obtain a CAM specifications from a CAD model of a machined part. The determination of the CAM specifications may comprise (*e.g.* automatically) checking if the CAD model has any geometric particularity (*e.g.* error or artefact) that may affect the production process and (*e.g.* automatically) correcting such particularities. For example, machining or milling based on the CAD model may not be carried out if the CAD model still comprises sharp edges (because the machining or milling tool cannot create sharp edges), and in such a case the determination of the CAM specifications may comprise (*e.g.* automatically) rounding or filleting such sharp edges (*e.g.* with a round or fillet radius that corresponds, *e.g.* substantially equals up to a tolerance error, the radius of the cutting head of the machining tool), so that machining or milling based on the CAD model can be done. More generally, the determination of the CAM specifications may automatically comprise rounding or filleting geometries within the CAD model that are incompatible with the radius of the machining or milling tool, to enable machining/milling. This check and possible corrections (*e.g.* rounding or filleting of geometries) may be carried out automatically as previously discussed, but also, by a user (*e.g.* a machining engineer), which performs the correction by hand on a CAD and/or CAM solution, *e.g.* the solution constraining the user to perform corrections that make the CAD model compliant with specifications of the tool used in the machining process.

Further to the check, the determination of the CAM specifications may comprise (*e.g.* automatically) determining the machining or milling path, *i.e.* the path to be taken by the machining tool to machine the product. The path may comprise a set of coordinates and/or a parameterized trajectory to be followed by the machining tool for machining, and determining the path may comprise (*e.g.* automatically) computing these coordinates and/or trajectory based on the CAD model. This computation may be based on the computation of a boundary of a Minkowski subtraction of the CAD model by a CAD model representation of the machining tool, as for example discussed in European Patent Application EP21306754.9 filed on 13 December 2021 by Dassault Systèmes, and which is incorporated herein by reference. It is to be understood that the path may be a single path, e.g. that the tool continuously follows without breaking contact with the material to be cut. Alternatively, the path may be a concatenation of a sequence sub-paths to be followed in a certain order by the tool, *e.g.* each being continuously followed by the tool without breaking contact with the material to be cut. Optionally, the determination of the CAM specifications may then comprise (*e.g.* automatically) setting machine parameters, including cutting speed, cut/pierce height, and/or mold opening stroke, for example based on the determined path and on the specification of the machine. Optionally, the determination of the CAM specifications may then comprise (*e.g.* automatically) configuring nesting where the CAM solution decides the best orientation for a part to maximize machining efficiency.

In this case of a machining or milling part, the determining of the CAM specifications thus results in, and outputs, the CAM specifications comprising a machining path, and optionally the set machine parameters and/or specifications of the configured nesting. This outputted CAM specifications may be then (*e.g.* directly and automatically) fed to the machining tool and/or the machining tool may then (*e.g.* directly and automatically) be programmed by reading the specifications, upon which the production process comprises the producing/manufacturing step where the machine performs the machining of the product according to the production specifications, *e.g.* by directly and automatically executing the production specifications. The machining process comprises the machining tool cutting a real-world block of material to reproduce the geometry and/or distribution of material captured by the CAD model, *e.g.* up to a tolerance error (*e.g.* tens of microns for milling).

The product/part may alternatively be a molded part, *i.e.* a part manufactured by molding (e*.g.* injection-molding). In such a case, the production process may comprise the step of determining the CAM specifications. This step may be carried out automatically, by any suitable CAM solution to automatically obtain a CAM specifications from a CAD model of a molded part. The determining of the CAM specifications may comprise (*e.g.* automatically) performing a sequence of molding checks based on the CAD model to check that the geometry and/or distribution of material captured by the CAD model is adapted for molding, and (*e.g.* automatically) performing the appropriate corrections if the CAD model is not adapted for molding. Performing the checks and the appropriate corrections (if any) may be carried out automatically, or, alternatively, by a user (*e.g.* a molding engineer), for example using a CAD and/or CAM solution that allows a user to perform the appropriate corrections on the CAD model but constraints him/her corrections that make the CAD model compliant with specifications of the molding tool(s). The checks may include: verifying that the virtual product as represented by the CAD model is consistent with the dimensions of the mold and/or verifying that the CAD model comprises all the draft angles required for demolding the product, as known *per se* from molding. The determining of the CAM specifications may then further comprise determining, based on the CAD model, a quantity of liquid material to be used for molding, and/or a time to let the liquid material harden/set inside the mold, and outputting CAM specifications comprising these parameters. The production process then comprises (*e.g.* automatically) performing the molding based on the outputted specifications, where the mold shapes, for the determined hardening time, a liquid material into a shape that corresponds to the geometry and/or distribution of material captured by the CAD model, *e.g.* up to a tolerance error (*e.g.* up to the incorporation of draft angles or to the modification of draft angles, for demolding).

The product/part may alternatively be a stamped part, also possibly referred to as "stamping part", *i.e.* a part to be manufactured in a stamping process. The production process may in this case comprise (*e.g.* automatically) determining CAM specifications based on the CAD model. The CAD model represents the stamping part, *e.g.* possible with one or more flanges if the part is to comprise some, and possibly in this latter case with extra material to be removed so as to form an unfolded state of one or more flanges of the part, as known *per se* from stamping. The CAD model thus comprises a portion that represents the part without the flanges (which is the whole part in some cases) and possibly an outer extra patch portion that represents the flanges (if any), with possibly the extra material (if any). This extra patch portion may present a g2-continuity over a certain length and then a g1-continuity over a certain length.

The determination of the CAM specifications may in this stamping case comprise (*e.g.* automatically) determining parameters of the stamping machine, for example a size of a stamping die or punch and/or a stamping force, based on the geometry and/or distribution of material of the virtual product as captured by the CAD model. If the CAD model also comprises the representation of the extra material to be removed so as to form an unfolded state of one or more flanges of the part, the extra material to be removed may for example be cut by machining, and determining the CAM specifications may also comprise determining a corresponding machining CAM specifications, *e.g.* as discussed previously. If there are one or more flanges, determining the CAM specifications may comprise determining geometrical specifications of the g2-continuity and g1-continuity portions that allow, after the stamping itself and the removal of the extra material, to fold in a folding process the flanges towards an inner surface of the stamped part and along the g2-continuity length. The CAM specifications thereby determined may thus comprise: parameters of the stamping tool, optionally said specifications for folding the flanges (if any), and optionally a machining production specifications for removing the extra material (if any).

The stamping production process may then output, *e.g.* directly and automatically, the CAM specifications, and perform the stamping process (*e.g.* automatically) based on the specifications. The stamping process may comprise stamping (*e.g.* punching) a portion of material to form the product as represented by the CAD specifications, that is possibly with the unfolded flanges and the extra material (if any). Where appropriate, the stamping process may then comprise cutting the extra material based on the machining production specifications and folding the flanges based on said specifications for folding the flanges, thereby folding the flanges on their g2-continuity length and giving a smooth aspect to the outer boundary of the part. In this latter case, the shape of the part once manufactured differ from its virtual counterpart as represented by the CAD model in that the extra material is removed and the flanges are folded, whereas the CAD model represents the part with the extra material and the flanges in an unfolded state.

The methods are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the methods may be performed through user-computer interaction, as for example specified for the method of use. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

FIG. 26 shows an example of the system, wherein the system is a client computer system, *e.g.* a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

## Claims

1. A computer-implemented method for machine-learning a function configured for predicting a next CAD feature in a CAD feature tree, the method comprising:
- providing a training dataset of training examples, each training example comprising a graph representing at least a part of a respective CAD feature tree, the graph comprising:
∘ nodes each representing a CAD feature of the respective CAD feature tree, each node being labeled with a label of a predetermined list of labels each indicating a type of CAD feature of a predetermined set of CAD feature types;
∘ edges each connecting two nodes and representing a parent-child relationship, in the respective CAD feature tree, between the CAD features represented by the two nodes; and
∘ ground truth data indicating a next CAD feature to predict according to one or more selected CAD features each corresponding to a node of the graph; and
- training the function based on the training dataset, the function being trained to take as input a graph representing at least a part of a CAD feature tree and to output a prediction of one or more next CAD features in the CAD feature tree, each predicted next CAD feature belonging to the predetermined set of CAD feature types.

2. The method of claim 1, wherein each training example further comprises data describing a global architecture of the respective CAD feature tree.

3. The method of claim 2, wherein the global data includes data describing:
- a number of CAD features in the respective CAD feature tree;
- a number of the one or more selected CAD features based on which a next CAD feature will be based;
- a dimension homogeneity of the one or more selected CAD features; and/or
- a number of different geometries of the respective CAD feature tree.

4. The method of claim 2 or 3, wherein the function is a neural network comprising:
- a Graph Neural Network (GNN) configured to take as input the input graph representing at least a part of a CAD feature tree and to output an encoding of the input graph;
- a linear encoder configured to encode the data describing the global architecture in a global feature encoding;
- a fusion module configured to output a fusion encoding corresponding to a fusion of the global feature encoding and of the encoding of the input graph; and
- a classifying module configured to take as input the fusion encoding and to output a the prediction of one or more next CAD features in the CAD feature tree.

5. The method of any one of claims 1 to 4, wherein each node comprises node attributes describing geometrical features of the geometry created by the CAD feature represented by the node.

6. The method of any one of claims 1 to 5, wherein the method comprises forming the training dataset, the forming the training dataset comprising:
- providing an initial set of graphs each representing a respective complete CAD feature tree, each graph of the initial set comprising:
∘ nodes each representing a CAD feature of the respective complete CAD feature tree, each node being labeled with a label of a predetermined list of labels each indicating a type of CAD feature of a predetermined set of CAD features; and
∘ edges each connecting two nodes and representing a parent-child relationship, in the respective complete CAD feature tree, between the CAD features represented by the two nodes;
- for each graph of the initial set, extracting subgraphs of the graph each representing at least a part of the respective CAD feature tree represented by the graph, the subgraphs thereby forming the training examples.

7. The method of claim 6, wherein the subgraphs have different depths.

8. The method of claim 6 or 7, wherein forming the training dataset further comprises:
- identifying one or more groups each of topologically similar subgraphs;
- for each group, selecting a subgraph representative of the group and labeling the selected subgraph with the labels of the other subgraphs of the group; and
- removing said other subgraphs.

9. The method of any one of claims 6 to 8, wherein providing the initial set of graphs comprises:
- providing a set of CAD feature trees;
- converting each CAD feature tree into a JSON file; and
- for each JSON file, forming a graph of the initial set based on the JSON file, the graph representing the respective CAD feature tree corresponding to the JSON file.

10. The method of claim 9, wherein providing the initial set of graphs further comprises, in each graph of the initial set, removing nodes corresponding to a CAD parameter, to a geometry not parameterized by a CAD feature, or a pure B-rep element.

11. A function learnable according to the method of any one of claims 1 to 10.

12. A computer-implemented method of use of the function according to claim 11, the method of use comprising one or more iterations of:
- providing a CAD feature tree;
- by a user, graphically selecting one or more CAD features in the CAD feature tree or one or more geometries created from the one or more CAD features;
- by using the function, predicting one or more next CAD features to add to the CAD feature tree based on the user selection and displaying graphical representations of the predicted one or more CAD feature to the user; and
- by the user, selecting a predicted CAD feature by graphically selecting the displayed graphical representation of the predicted CAD feature, thereby adding the CAD feature to the CAD feature tree,
wherein if there is more than one iteration, at each iteration, the CAD feature tree to which the user-selected CAD feature is added forms the provided CAD feature tree of the next iteration.

13. A computer program comprising instructions which, when executed by a computer system, cause the computer system to perform the method of any one of claims 1 to 10 and/or the method of use of claim 12.

14. A computer-readable data storage medium having recorded thereon the computer program of claim 13 and/or the function of claim 11.

15. A computer system comprising a processor coupled to a memory, the memory having recorded therein the computer program of claim 13 and/or the function of claim 11.

## Amended claims

### Amended claims in accordance with Rule 137(2) EPC.

1. A computer-implemented method for machine-learning a function configured for predicting a next CAD feature in a CAD feature tree, the method comprising:
- providing a training dataset of training examples, each training example comprising a graph representing at least a part of a respective CAD feature tree, the graph comprising:
o nodes each representing a CAD feature of the respective CAD feature tree, each node being labeled with a label of a predetermined list of labels each indicating a type of CAD feature of a predetermined set of CAD feature types;
o edges each connecting two nodes and representing a parent-child relationship, in the respective CAD feature tree, between the CAD features represented by the two nodes; and
o ground truth data indicating a next CAD feature to predict according to one or more selected CAD features each corresponding to a node of the graph;
each training example further comprising data describing a global architecture of the respective CAD feature tree, wherein the global data includes data describing:
o a number of CAD features in the respective feature tree;
o a number of CAD features in the respective CAD feature tree;
o a number of the one or more selected CAD features based on which a next CAD feature will be based;
o if there are more than one selected CAD features, a dimension homogeneity of the selected CAD features; and/or;
o a number of different geometries of the respective CAD feature tree;
- training the function based on the training dataset, the function being trained to take as input a graph representing at least a part of a CAD feature tree and to output a prediction of one or more next CAD features in the CAD feature tree, each predicted next CAD feature belonging to the predetermined set of CAD feature types, wherein the function is a neural network comprising:
o a Graph Neural Network (GNN) configured to take as input the input graph representing at least a part of a CAD feature tree and to output an encoding of the input graph;
o a linear encoder configured to encode the data describing the global architecture in a global feature encoding;
o a fusion module configured to output a fusion encoding corresponding to a fusion of the global feature encoding and of the encoding of the input graph; and
o a classifying module configured to take as input the fusion encoding and to output a the prediction of one or more next CAD features in the CAD feature tree,
- performing a method of use of the trained function, the method of use comprising one or more iterations of:
o providing a CAD feature tree;
o by a user, graphically selecting one or more CAD features in the CAD feature tree or one or more geometries created from the one or more CAD features;
o by using the function, predicting one or more next CAD features to add to the CAD feature tree based on the user selection and displaying graphical representations of the predicted one or more CAD feature to the user; and
o by the user, selecting a predicted CAD feature by graphically selecting the displayed graphical representation of the predicted CAD feature, thereby adding the CAD feature to the CAD feature tree,
wherein if there is more than one iteration, at each iteration, the CAD feature tree to which the user-selected CAD feature is added forms the provided CAD feature tree of the next iteration.

2. The method of claim 1, wherein each node comprises node attributes describing geometrical features of the geometry created by the CAD feature represented by the node.

3. The method of any one of claims 1 to 2, wherein the method comprises forming the training dataset, the forming the training dataset comprising:
- providing an initial set of graphs each representing a respective complete CAD feature tree, each graph of the initial set comprising:
o nodes each representing a CAD feature of the respective complete CAD feature tree, each node being labeled with a label of a predetermined list of labels each indicating a type of CAD feature of a predetermined set of CAD features; and
o edges each connecting two nodes and representing a parent-child relationship, in the respective complete CAD feature tree, between the CAD features represented by the two nodes;
- for each graph of the initial set, extracting subgraphs of the graph each representing at least a part of the respective CAD feature tree represented by the graph, the subgraphs thereby forming the training examples.

4. The method of claim 3, wherein the subgraphs have different depths.

5. The method of claim 3 or 4, wherein forming the training dataset further comprises:
- identifying one or more groups each of topologically similar subgraphs;
- for each group, selecting a subgraph representative of the group and labeling the selected subgraph with the labels of the other subgraphs of the group; and
- removing said other subgraphs.

6. The method of any one of claims 3 to 5, wherein providing the initial set of graphs comprises:
- providing a set of CAD feature trees;
- converting each CAD feature tree into a JSON file; and
- for each JSON file, forming a graph of the initial set based on the JSON file, the graph representing the respective CAD feature tree corresponding to the JSON file.

7. The method of claim 6, wherein providing the initial set of graphs further comprises, in each graph of the initial set, removing from the graph each node which corresponds to a CAD parameter, to a geometry not parameterized by a CAD feature, or to a pure B-rep element.

8. A computer program comprising instructions which, when executed by a computer system, cause the computer system to perform the method of any one of claims 1 to 7.

9. A computer-readable data storage medium having recorded thereon the computer program of claim 8 and/or a function learnable according to the method of any one of claims 1 to 7.

10. A computer system comprising a processor coupled to a memory, the memory having recorded therein the computer program of claim 8 and/or a function learnable according to the method of any one of claims 1 to 7.
